(19) **Europäisches Patentamt**
**European Patent Office**
**Office européen des brevets**

(11) **EP 4 394 755 A1**

(12) **EUROPEAN PATENT APPLICATION**
published in accordance with Art. 153(4) EPC

(43) Date of publication:
**03.07.2024 Bulletin 2024/27**

(21) Application number: **22876646.5**

(22) Date of filing: **21.07.2022**

(51) International Patent Classification (IPC):
**G09G 3/3225** (2016.01)   **G09G 3/3266** (2016.01)
**H10K 59/00** (2023.01)   **G06V 40/13** (2022.01)
**G06F 3/041** (2006.01)

(52) Cooperative Patent Classification (CPC):
**H01L 27/14603; G06V 40/1318; G09G 3/20;**
**G09G 3/3233; G09G 3/3258; H10K 59/1213;**
**H10K 59/131;** G09G 2300/0814; G09G 2320/043;
G09G 2320/045; H10K 59/352; H10K 59/353;
H10K 59/38; H10K 59/65

(86) International application number:
**PCT/KR2022/010673**

(87) International publication number:
**WO 2023/054871 (06.04.2023 Gazette 2023/14)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **30.09.2021   KR 20210130074**

(71) Applicant: **Samsung Display Co., Ltd.**
**Yongin-si, Gyeonggi-do 17113 (KR)**

(72) Inventors:
• **JO, Kang Bin**
**Suwon-si Gyeonggi-do 16670 (KR)**
• **YANG, Dong Wook**
**Suwon-si Gyeonggi-do 16694 (KR)**
• **LEE, Jong Hyun**
**Suwon-si Gyeonggi-do 16708 (KR)**
• **KIM, Il Nam**
**Hwaseong-si Gyeonggi-do 18504 (KR)**

(74) Representative: **Walaski, Jan Filip et al**
**Venner Shipley LLP**
**200 Aldersgate**
**London EC1A 4HD (GB)**

(54) **DISPLAY DEVICE**

(57)    The present invention relates to a display device that can provide a display panel including both display pixels and light-sensing pixels, despite a lack of arrangement space. According to an embodiment of the present disclosure, a display device including a substrate comprising a display area displaying an image and a non-display area disposed around the display area, display pixels, each including a light emitting element disposed in the display area and a pixel driver connected to the light emitting element, and light sensing pixels, each including a light receiving element and a fingerprint driver connected to the light receiving element. The fingerprint driver includes at least one transistor, and the light receiving element is disposed in the display area, and the at least one transistor of the fingerprint driver is disposed in the non-display area.

**FIG. 5**

EP 4 394 755 A1

**Description**

[Technical Field]

Embodiments of the present disclosure relate to a display device.

[Background Art]

A display device is applied to various electronic devices such as a smartphone, a tablet, a notebook computer, a monitor, and a television (TV). With the recent advance of mobile communication technology, the use of portable electronic devices such as a smartphone, a tablet, and a notebook computer has increased enormously. Privacy information is stored in the portable electronic device. Accordingly, in order to protect the privacy information of the portable electronic device, it has been typical to use fingerprint authentication in which a fingerprint as user's biometric information is used for authentication.

For example, the display device may authenticate a user's fingerprint using an optical method, an ultrasonic method, a capacitive method, or the like. The optical method may authenticate the user's fingerprint by detecting light reflected from the user's fingerprint.

[Disclosure]

[Technical Problem]

The display device may include a display panel including display pixels for displaying an image and light sensing pixels for sensing light, in order to optically authenticate the user's fingerprint. In this case, not only the display pixels but also the light sensing pixels need to be arranged in the display panel, so that a space for arranging the light sensing pixels may be insufficient.

Aspects of the present disclosure provide a display device capable of providing a display panel in which a space for display pixels does not need to be reduced in order to provide a space for arranging light sensing pixels.

The problems of the present invention are not limited to the problems mentioned above, and other technical problems not mentioned will be clearly understood by those skilled in the art from the description below.

[Technical Solution]

According to an embodiment of the present disclosure, a display device including a substrate comprising a display area displaying an image and a non-display area disposed around the display area, display pixels, each including a light emitting element disposed in the display area and a pixel driver connected to the light emitting element, and light sensing pixels, each including a light receiving element and a fingerprint driver connected to the light receiving element. The fingerprint driver includes at least one transistor, and the light receiving element is disposed in the display area, and the at least one transistor of the fingerprint driver is disposed in the non-display area.

The fingerprint driver may be disposed on a first side of the display area.

The display device may further include a display scan driver disposed in the non-display area and configured to output scan signals to the pixel driver, and a fingerprint scan driver disposed in the non-display area and configured to output fingerprint scan signals to the fingerprint driver.

The display scan driver may be disposed on a second side of the display area.

The fingerprint scan driver may be disposed at a corner where the first side and the second side of the display area meet.

The fingerprint scan driver may be disposed on the first side of the display area.

The fingerprint scan driver may be disposed at a corner where the first side and the second side of the display area meet and on the first side of the display area.

The pixel driver may include a driving transistor configured to control a driving current flowing through the light emitting element according to a data voltage applied to a gate electrode, a first transistor connected the gate electrode of the driving transistor to a driving voltage line to which a driving voltage is applied according to a display initialization signal, a second transistor connected a source electrode of the driving transistor to a data line according to a display write signal, and a third transistor connected an anode electrode of the light emitting element to the driving voltage line according to a display control signal.

The fingerprint driver may include a first sensing transistor connected a fingerprint connection line connected to a light receiving anode electrode of the light receiving element to a sensing line according to a fingerprint scan signal of a fingerprint scan line.

The fingerprint scan signal may be same as the display initialization signal.

The fingerprint scan signal may be same as the display control signal.

The first sensing transistor may be disposed in the non-display area.

the fingerprint driver may further include a second sensing transistor connected the fingerprint connection line to the driving voltage line to which the driving voltage is applied according to a fingerprint initialization signal of a fingerprint initialization line.

The second sensing transistor may be disposed in the non-display area.

The fingerprint initialization signal may be same as the display write signal.

The fingerprint driver may include a first sensing transistor configured to control a sensing current flowing through a sensing line according to a voltage of a light receiving anode electrode of the light receiving element, a second optical transistor configured to initialize the light receiving anode electrode according to a fingerprint initialization signal of a fingerprint initialization line, and a third sensing transistor connected a drain electrode of the first sensing transistor to the sensing line according to a fingerprint scan signal of the fingerprint scan line.

The first sensing transistor, the second sensing transistor, and the third sensing transistor may be disposed in the non-display area.

The first sensing transistor and the third sensing transistor may be disposed in the non-display area, and the second sensing transistor may be disposed in the display area.

The fingerprint scan signal may be same as the display initialization signal, and the fingerprint initialization signal may be same as the display write signal.

According to an embodiment of the present disclosure, a display device including a substrate including a display area displaying an image and a non-display area disposed around the display area, and light sensing pixels, each comprising a light receiving element and a fingerprint driver connected to the light receiving element. The fingerprint driver includes a plurality of transistors. The light receiving element may be disposed in the display area, at least one of the plurality of transistors of the fingerprint driver may be disposed in the non-display area, and another one of the plurality of transistors may be disposed in the display area.

According to an embodiment of the present disclosure, a display device including a substrate including a display area displaying an image and a non-display area disposed around the display area, display pixels, each including a light emitting element disposed in the display area and a pixel driver connected to the light emitting element, light sensing pixels, each including a light receiving element and a fingerprint driver connected to the light receiving element, and a scan driver disposed in the non-display area and configured to apply scan signals to the pixel driver and apply fingerprint scan signals to the fingerprint driver.

The fingerprint driver may include at least one transistor, the light receiving element may be disposed in the display area, and the at least one transistor of the fingerprint driver may be disposed in the non-display area.

Specific details of other embodiments are included in the detailed description and drawings.

[Advantageous Effects]

In a display device including the embodiments of the present disclosure, light receiving elements of a light sensing portion are formed in a display area together with the light emitting elements of light emitting portions, and are connected one-to-one to fingerprint drivers disposed in a non-display area using sensing connection lines. Accordingly, there is no need to reduce the space where first to fourth pixel drivers are disposed in order to provide a space for arranging the fingerprint drivers.

Effects according to the embodiments are not limited to the contents exemplified above, and further various effects are included in the present specification.

[Description of Drawings]

FIG. 1 is a perspective view illustrating a display device according to one embodiment.

FIG. 2 is a plan view illustrating a display panel and a display driving circuit according to one embodiment.

FIG. 3 is a plan view illustrating a display panel and a display driving circuit according to another embodiment.

FIG. 4 is a plan view illustrating a display panel and a display driving circuit according to still another embodiment.

FIG. 5 is a block diagram illustrating a display device according to one embodiment.

FIG. 6 is a circuit diagram illustrating a display pixel and a light sensing pixel according to one embodiment.

FIG. 7 is an exemplary diagram illustrating a display scan driver according to one embodiment.

FIG. 8 is an exemplary diagram illustrating a fingerprint scan driver according to one embodiment.

FIG. 9 is a waveform diagram illustrating scan signals inputted to a light sensing pixel and a display pixel according to one embodiment.

FIG. 10 is a layout diagram illustrating an image display area according to one embodiment.

FIG. 11 is a layout diagram illustrating a fingerprint sensing area according to one embodiment.

FIG. 12 is an exemplary diagram illustrating light sensing portions of a fingerprint sensing area and fingerprint drivers according to one embodiment.

FIGS. 13 and 14 are layout views illustrating area A of FIG. 11 in detail.

FIG. 15A is a cross-sectional view illustrating an example of a display panel taken along line A-A' of FIG. 14.

FIG. 15B is a cross-sectional view illustrating an example of a display panel taken along line B-B' of FIG. 14.

FIG. 16 is a circuit diagram illustrating a light sensing pixel and a first display pixel of a display pixel according to another embodiment.

FIG. 17 is a waveform diagram illustrating scan signals inputted to a light sensing pixel and a first display pixel of a display pixel according to still another embodiment.

FIG. 18 is an exemplary diagram illustrating light sensing portions of a fingerprint sensing area and fingerprint drivers according to still another embodiment.

FIG. 19 is a circuit diagram illustrating a light sensing pixel and a first display pixel of a display pixel according to still another embodiment.

FIG. 20 is an exemplary diagram illustrating light sensing portions of a fingerprint sensing area and fingerprint drivers according to still another embodiment.

FIG. 21 is an exemplary diagram illustrating light sensing portions of a fingerprint sensing area and fingerprint drivers according to still another embodiment.

FIG. 22 is a layout diagram illustrating a display panel and a display driving circuit according to still another embodiment.

FIG. 23 is a block diagram illustrating a display device according to still another embodiment.

FIG. 24 is an exemplary diagram illustrating light sensing portions of a fingerprint sensing area and fingerprint drivers according to still another embodiment.

FIG. 25 is an exemplary diagram illustrating light sensing portions of a fingerprint sensing area and fingerprint drivers according to still another embodiment.

FIG. 26 is an exemplary diagram illustrating light sensing portions of a fingerprint sensing area and fingerprint drivers according to still another embodiment.

FIG. 27 is an exemplary diagram illustrating light sensing portions of a fingerprint sensing area and fingerprint drivers according to still another embodiment.


[Mode for Invention]

The advantages and features of the present invention and methods for achieving them will become clear by referring to the embodiments described in detail below along with the accompanying drawings. However, the present invention is not limited to the embodiments disclosed below and will be implemented in various different forms. The present embodiments only serve to ensure that the disclosure of the present invention is complete and that common knowledge in the technical field to which the present invention pertains is not limited. It is provided to fully inform those who have the scope of the invention, and the present invention is only defined by the scope of the claims.

When an element or layer is referred to as "on" another element or layer, it includes instances where the element or layer is directly on top of or intervening with the other element. Like reference numerals refer to like elements throughout the specification. The shape, size, ratio, angle, number, etc. disclosed in the drawings for explaining the embodiments are illustrative and the present invention is not limited to the details shown.

Although first, second, etc. are used to describe various components, these components are, of course, not limited by these terms. These terms are merely used to distinguish one component from another. Therefore, it goes without saying that the first component mentioned below may also be a second component within the technical spirit of the present invention.

Each feature of the various embodiments of the present invention can be combined or combined with each other, partially or entirely, and various technical interconnections and operations are possible, and each embodiment may be implemented independently of each other or together in a related relationship. It may be possible.

Hereinafter, specific embodiments will be described with reference to the attached drawings.

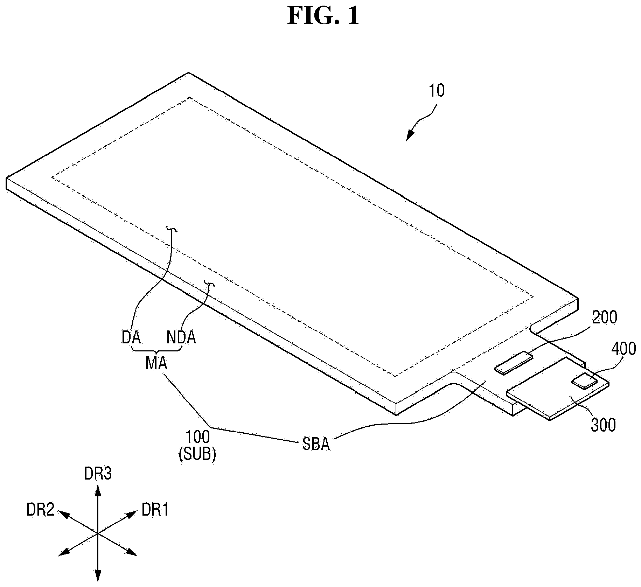

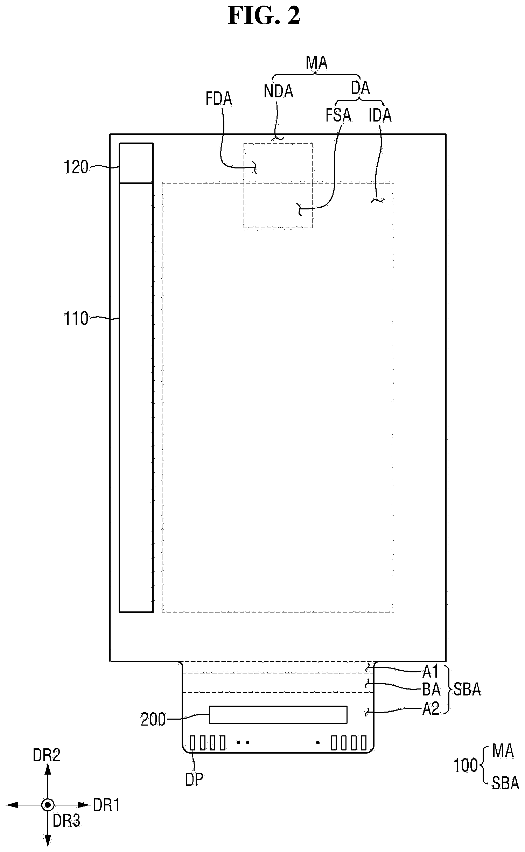

FIG. 1 is a perspective view illustrating a display device according to one embodiment. FIG. 2 is a plan view illustrating a display panel and a display driving circuit according to one embodiment.

Referring to FIGS. 1 and 2, a display device 10 is a device for displaying a moving image or a still image. The display device 10 may be used as a display screen of various devices, such as a television, a laptop computer, a monitor, a billboard and an Internet-of-Things (IOT) device, as well as portable electronic devices such as a mobile phone, a smartphone, a tablet personal computer (PC), a smart watch, a watch phone, a mobile communication terminal, an electronic notebook, an electronic book, a portable multimedia player (PMP), a navigation device and an ultra-mobile PC (UMPC).

The display device 10 may be a light emitting display device such as an organic light emitting display using an organic light emitting diode, a quantum dot light emitting display including a quantum dot light emitting layer, an inorganic light emitting display including an inorganic semiconductor, and a micro light emitting display using a micro or nano light emitting diode (LED). In the following description, it is assumed that the display device 10 is an organic light emitting display device, but the present disclosure is not limited thereto.

The display device 10 includes a display panel 100, a display driving circuit 200, and a circuit board 300.

The display panel 100 may, in plan view, be formed in a rectangular shape having short sides in a first direction DR1 and long sides in a second direction DR2 crossing the first direction DR1. A corner where the short side in the first direction DR1 and the long side in the second direction DR2 meet may be right-angled or rounded to have a predetermined curvature. The planar shape of the display panel 100 is not limited to the rectangular shape, and may be formed in another polygonal shape, a circular shape or an elliptical shape. The display panel 100 may be formed to be flat, but is not limited thereto. For example, the display panel 100 may include a curved portion formed at left and right ends and having a predetermined curvature or a varying curvature. In addition, the display panel 100 may be formed flexibly so that it can be curved, bent, folded, or rolled.

A substrate SUB of the display panel 100 may include a main region MA and a sub-region SBA.

The main region MA may include a display area DA displaying an image and a non-display area NDA that is a peripheral area of the display area DA.

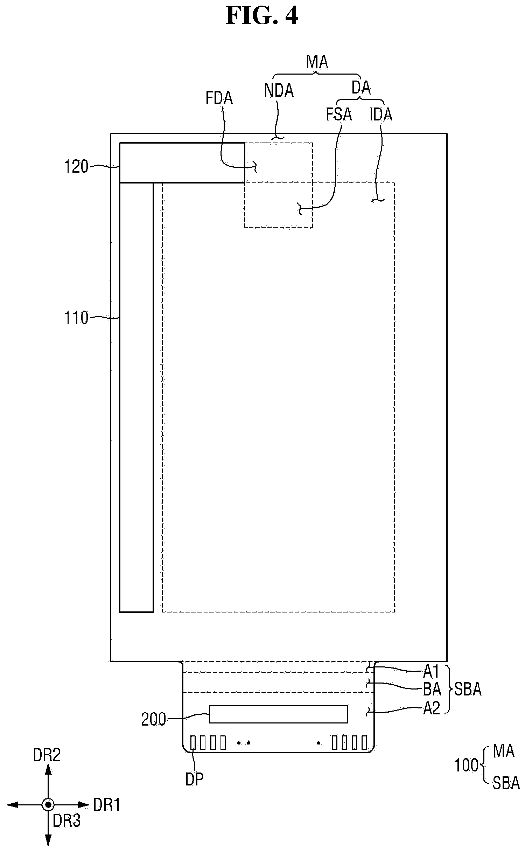

The display area DA may include display pixels ('SPX' in FIG. 4) for displaying an image. The display area DA may occupy most of the main region MA. The display area DA may be disposed at the center of the main region MA.

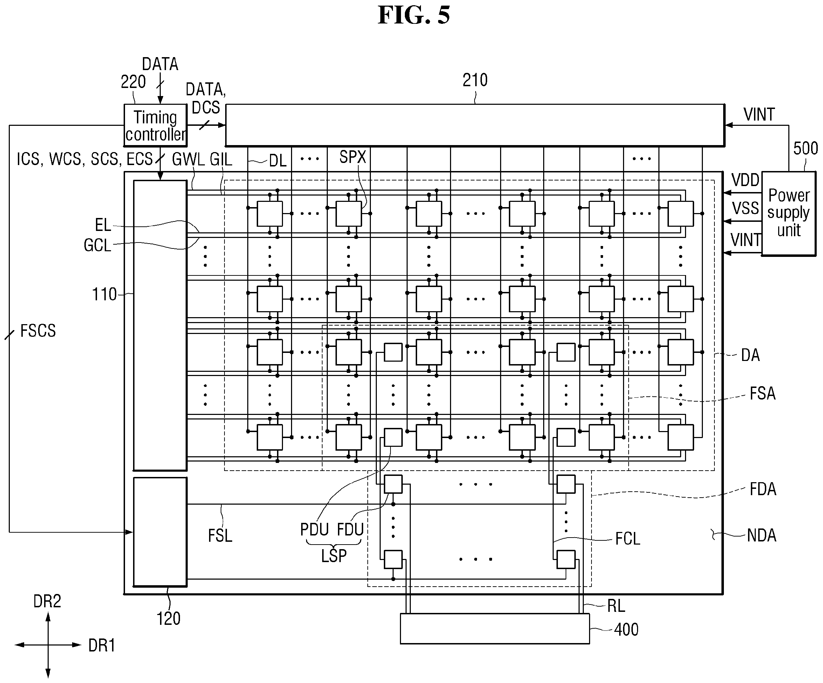

The display area DA may include an image display area IDA and a fingerprint sensing area FSA. The fingerprint sensing area FSA may include a light sensing portion PDU (see FIG. 5) of each of light sensing pixels LSP (see FIG. 5) that not only displays an image but also senses light to detect a user's fingerprint. The image display area IDA may be an area excluding the fingerprint sensing area FSA from the display area DA, and may only display an image without detecting the user's fingerprint.

The fingerprint sensing area FSA may be a part of the display area DA, but the embodiment of the present disclosure is not limited thereto. The display area DA may include only the fingerprint sensing area FSA without including the image display area IDA. In this case, the fingerprint sensing area FSA may be substantially the same as the display area DA. That is, the entire display area DA may be the fingerprint sensing area FSA.

Although the fingerprint sensing area FSA is illustrated in FIG. 2 to be disposed at the center of one edge, e.g., the upper edge of the display area DA, the embodiment of the present disclosure is not limited thereto. The fingerprint sensing area FSA may be disposed apart from one edge of the display area DA. Alternatively, the fingerprint sensing area FSA may be disposed to at a side of an edge of the display area DA. For example, the fingerprint sensing area FSA may be disposed at the left or right side of the upper edge of the display area DA.

The non-display area NDA may be disposed adjacent to the display area DA. The non-display area NDA may be an area outside the display area DA. The non-display area NDA may be disposed to surround the display area DA. The non-display area NDA may be an edge area of the display area DA.

As shown in FIG. 2, a fingerprint driving area FDA may be provided in the non-display area NDA. The fingerprint driving area FDA may include a fingerprint driver FDU (see FIG. 5) of each of the light sensing pixels LSP (see FIG. 5). The fingerprint driving area FDA may be a part of the non-display area NDA.

The fingerprint driving area FDA may be disposed adjacent to the fingerprint sensing area FSA. For example, the fingerprint driving area FDA may be, as shown in FIG. 2, disposed above the fingerprint sensing area FSA of the display area DA. In the fingerprint driving area FDA, the light sensing portion PDU of each of the light sensing pixels LSP (see FIG. 5) may be connected to a sensing line according to a fingerprint scan signal applied from a fingerprint scan driver 120.

The sensing line may be connected to a fingerprint driving circuit 400. The fingerprint driving circuit 400 may be formed as an integrated circuit (IC) and attached to the circuit board 300.

The sub-region SBA may protrude from one side of the main region MA in the second direction DR2. The length of the sub-region SBA in the second direction DR2 may be less than the length of the main region MA in the second direction DR2. The length of the sub-region SBA in the first direction DR1 may be substantially equal to or less than the length of the main region MA in the first direction DR1. Alternatively, the sub-region SBA protrudes from one side of the main region MA in the first direction DR1.

Although the sub-region SBA is illustrated in an unfolded condition in FIGS. 1 and 2, the sub-region SBA may be bent, and in this case, the sub-region SBA may be disposed below the main region MA. The sub-region SBA may overlap the main region MA in a third direction DR3.

The sub-region SBA may include a first area A1, a second area A2, and a bending area BA.

The first area A1 is a region protruding from one side of the main region MA in the second direction DR2. One side of the first area A1 may be in contact with the non-display area NDA of the main region MA, and the other side of the first region A1 may be in contact with the bending area BA.

The second area A2 is an area on which pads DP and the display driving circuit 200 are disposed. The display driving circuit 200 may be attached to driving pads of the second area A2 using a conductive adhesive member such as an anisotropic conductive film. The circuit board 300 may be attached to the pads DP of the second area A2 using a conductive adhesive member. One side of the second area A2 may be in contact with the bending area BA.

The bending area BA is an area being bent. When the bending area BA is bent, the second area A2 may be disposed under the first area A1 and under the main region MA. The bending area BA may be disposed between the first area A1 and the second area A2. One side of the bending area BA may be in contact with the first area A1, and the other side of the bending area BA may be in contact with the second area A2.

The display driving circuit 200 may generate signals and voltages for driving the display panel 100. The display driving circuit 200 may be formed as an integrated circuit (IC) and attached onto the display panel 100 by a chip on glass (COG) method, a chip on plastic (COP) method, or an ultrasonic bonding method, but the present disclosure is not limited thereto. For example, the display driving circuit 200 may be attached onto the circuit board 300 by a chip on film (COF) method.

The circuit board 300 may be attached to one end of the sub-region SBA of the display panel 100. Thus, the circuit board 300 may be electrically connected to the display panel 100 and the display driving circuit 200. The display panel 100 and the display driving circuit 200 may receive digital video data, timing signals, and driving voltages through the circuit board 300. The circuit board 300 may be a flexible printed circuit board, a printed circuit board, or a flexible film such as a chip on film.

A display scan driver 110 may be provided in the non-display area NDA. Although the display scan driver 110 is illustrated to be disposed on one side (e.g., left side) of the display panel 100, the embodiment of the present disclosure is not limited thereto. For example, the display scan driver 110 may be disposed on both sides (e.g., left and right sides) of the display panel 100. The display scan driver 110 may be electrically connected to the display driving circuit 200 through scan fan-out lines. The display scan driver 110 may receive a scan control signal from the display driving circuit 200, generate scan signals according to the scan control signal, and output the scan signals to scan lines.

The fingerprint scan driver 120 may be disposed in the non-display area NDA. The fingerprint scan driver 120 may be electrically connected to the display driving circuit 200 through fingerprint fan-out lines. The fingerprint scan driver 120 may receive a fingerprint scan control signal from the display driving circuit 200, generate fingerprint scan signals according to the fingerprint scan control signal, and output the fingerprint scan signals to fingerprint scan lines.

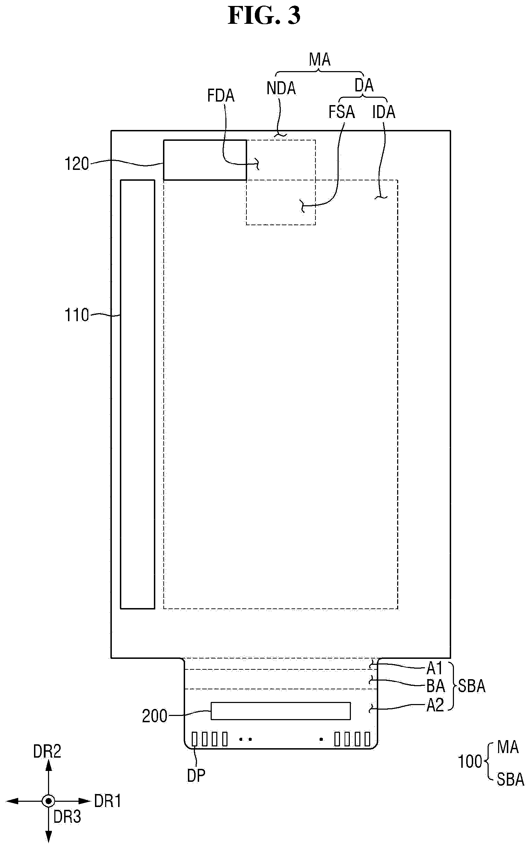

Meanwhile, as shown in FIG. 2, the fingerprint scan driver 120 may be disposed at a corner where the left and upper sides of the display area DA meet, and may be disposed above the display scan driver 110. Alternatively, as shown in FIG. 3, the fingerprint scan driver 120 may be disposed to the upper side of the display area DA and may be disposed to the left side of the fingerprint driving area FDA. Alternatively, as shown in FIG. 4, the fingerprint scan driver 120 may be disposed above the display scan driver 110 and on the upper side of the display panel 100 and may be disposed to the left side of the fingerprint driving area FDA.

FIG. 5 is a block diagram illustrating a display device according to one embodiment.

Referring to FIG. 5, the display device according to one embodiment includes the display panel 100, the display scan driver 110, the fingerprint scan driver 120, the display driving circuit 200, and a power supply unit 500. The display driving circuit 200 may include a data driver 210 and a timing controller 220.

The display panel 100 may include the display pixels SPX disposed in the display area DA, the light sensing pixels LSP, display write lines GWL, display initialization lines GIL, display control lines GCL, emission lines EL, data lines DL, fingerprint scan lines FSL, sensing connection lines FCL, and sensing lines RL. The display panel 100 may include the display scan driver 110, the fingerprint driver FDU, and the fingerprint scan driver 120 disposed in the non-display area NDA.

The display write lines GWL, the display initialization lines GIL, the display control lines GCL, the emission lines EL, and the fingerprint scan lines FSL may extend in the first direction DR1. The data lines DL, the sensing connection lines FCL, and the sensing lines RL may extend in the second direction DR2.

The display pixels SPX may be arranged in a matrix form in the first direction DR1 and the second direction DR2 in the display area DA. Each of the display pixels SPX may be connected to one of the display write lines GWL, one of the display initialization lines GIL, one of the display control lines GCL, and one of the emission lines EL. Each of the display pixels SPX may receive a data voltage of the data line DL according to a display write signal of the display write line GWL, a display initialization signal of the display initialization line GIL, a display control signal of the display control line GCL, and an emission signal of the emission line EL, and may supply a driving current to the light emitting element according to the data voltage to emit light.

Each of the light sensing pixels LSP may include the light sensing portion PDU and the fingerprint driver FDU. The light sensing portion PDU of each of the light sensing pixels LSP may be disposed in the fingerprint sensing area FSA, and the fingerprint driver FDU thereof may be disposed in the fingerprint driving area FDA.

The light sensing portions PDU may be arranged in a matrix form in the first direction DR1 and the second direction DR2 in the fingerprint sensing area FSA. The light sensing portions PDU may be one-to-one connected to the fingerprint drivers FDU through the sensing connection lines FCL. That is, the light sensing portion PDU may be connected to the fingerprint driver FDU through the sensing connection line FCL.

The fingerprint drivers FDU may be arranged in a matrix form in the first direction DR1 and the second direction DR2. Each of the fingerprint drivers FDU may be connected to one of the fingerprint scan lines FSL, one of the sensing connection lines FCL, and one of the sensing lines RL. Each of the fingerprint drivers FDU may connect the sensing connection line FCL connected to the light sensing portion PDU to the sensing line RL according to a fingerprint scan signal of the fingerprint scan line FSL.

The fingerprint driving circuit 400 may be connected to the sensing lines RL. The fingerprint driving circuit 400 may detect a fingerprint according to the sensing voltages of the sensing lines RL. For example, light outputted from the display panel 100 may be reflected from a ridge and a valley of the user's fingerprint disposed in the fingerprint sensing area FSA. In this case, the amount of light reflected from the ridge of the fingerprint and the amount of light reflected from the valley of the fingerprint may be different. Therefore, the voltage (sensing voltage) of the anode electrode of a light receiving element of the light sensing portion PDU may vary depending on whether it is the light reflected from the ridge of the fingerprint or the light reflected from the valley of the fingerprint. Therefore, the sensing voltage detected by the light sensing portion PDU may vary depending on whether it is the light reflected from the ridge of the fingerprint of a finger F or the light reflected from the valley of the fingerprint of the finger F. The fingerprint driving circuit 400 may recognize the fingerprint according to the sensing voltages of the sensing lines RL.

The display scan driver 110 may be connected to the display write lines GWL, the display initialization lines GIL, the display control lines GCL, and the emission lines EL. The display scan driver 110 may include a display signal output unit for outputting display write signals applied to the display write lines GWL, display initialization signals applied to the display initialization lines GIL, and display control signals applied to the display control lines GCL, and an emission signal output unit for outputting emission signals applied to the emission lines EL.

The display scan driver 110 may receive a write control signal WCS, an initialization control signal ICS, a scan control signal SCS, and an emission control signal ECS from the timing controller 220. The display signal output unit of the display scan driver 110 may generate the display write signals according to the write control signal WCS and output them to the display write lines GWL. In addition, the display signal output unit of the display scan driver 110 may generate the display initialization signals according to the initialization control signal ICS and output them to the display initialization lines GIL. In addition, the display signal output unit of the display scan driver 110 may generate the display control signals according to the scan control signal SCS and output them to the display control lines GCL. Further, the emission signal output unit of the display scan driver 110 may generate the emission signals according to the emission control signal ECS and output them to the emission lines EL.

The fingerprint scan driver 120 may be connected to the fingerprint scan lines FSL. The fingerprint scan driver 120 may receive a fingerprint scan control signal FSCS from the timing controller 220. The fingerprint scan driver 120 may generate the fingerprint scan signals according to the fingerprint scan control signal FSCS and output them to the fingerprint scan lines FSL.

The data driver 210 converts digital video data DATA into data voltages and outputs them to the data lines DL. The data driver 210 may output data voltages in synchronization with the display write signals. Therefore, the display pixels SPX may be selected by the display write signals of the display scan driver 110, and a data voltage may be supplied to each of the selected display pixels SPX.

The timing controller 220 receives the timing signals and the digital video data DATA from an external graphic device. For example, the external graphic device may be a graphic card of a computer, a set-top box, or the like, but the embodiment of the present disclosure is not limited thereto.

The timing controller 220 may generate the write control signal WCS, the initialization control signal ICS, the scan control signal SCS, and the emission control signal ECS to control the operation timing of the display scan driver 110 according to the timing signals. In addition, the timing controller 220 may generate the fingerprint scan control signal FSCS for controlling the operation timing of the fingerprint scan driver 120 according to the timing signals. In addition, the timing controller 220 may generate a data control signal DCS for controlling the operation timing of the data driver 210 according to the timing signals.

The timing controller 220 outputs the write control signal WCS, the initialization control signal ICS, the scan control signal SCS, and the emission control signal ECS to the display scan driver 110. The timing controller 220 outputs the fingerprint scan control signal FSCS to the fingerprint scan driver 120. The timing controller 220 outputs the digital video data DATA and the data control signal DCS to the data driver 210.

The power supply unit 500 may generate a plurality of driving voltages and output them to the display panel 100. The power supply unit 500 may output a first driving voltage VDD, a second driving voltage VSS, and a third driving voltage VINT to the display panel 100. The first driving voltage VDD may be a high potential driving voltage, the second driving voltage VSS may be a low potential driving voltage, and the third driving voltage VINT may be a voltage for initializing the gate electrode of a driving transistor of each of the display pixels.

As shown in FIG. 5, the light sensing portion PDU of each of the light sensing pixels LSP for detecting the fingerprint may be disposed in the fingerprint sensing area FSA which is a part of the display area DA, and the fingerprint driver FDU may be disposed in the fingerprint driving area FDA which is a part of the non-display area NDA. Therefore, it is not necessary to reduce the space of the display pixels SPX in the display area DA to provide a space in which the light sensing pixels LSP are disposed.

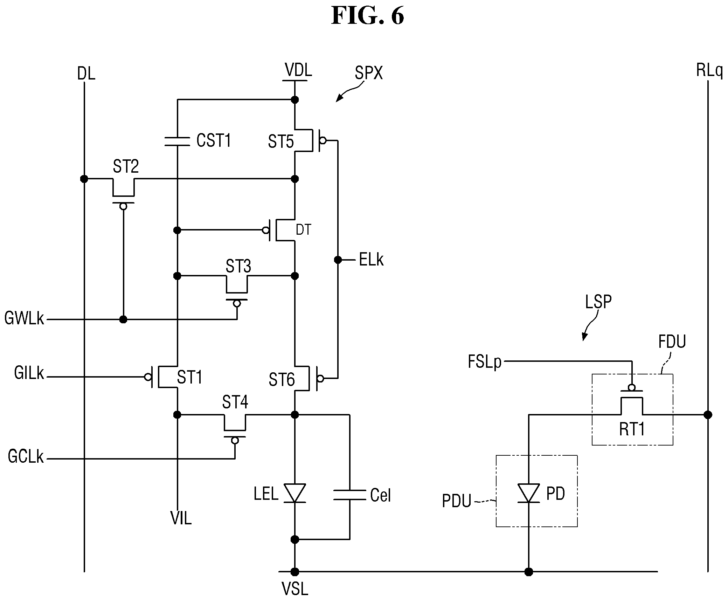

FIG. 6 is a circuit diagram illustrating a display pixel and a light sensing pixel according to one embodiment.

Referring to FIG. 6, the display pixel SPX according to one embodiment may be connected to a $k^{th}$ (k being a positive integer) display initialization line GILk, a $k^{th}$ display write line GWLk, and a $k^{th}$ display control line GCLk. In addition, the display pixel SPX may be connected to a first driving voltage line VDL to which the first driving voltage is supplied, a second driving voltage line VSL to which the second driving voltage is supplied, and a third driving voltage line VIL to which the third driving voltage is supplied.

The display pixel SPX may include a light emitting portion ELU and a pixel driver DDU. The light emitting portion ELU may include a light emitting element LEL. The pixel driver DDU may include a driving transistor DT, switch elements, and a capacitor CST1. The switch elements include first to sixth transistors ST1, ST2, ST3, ST4, ST5, and ST6.

The driving transistor DT may include a gate electrode, a first electrode, and a second electrode. The driving transistor DT controls a drain-source current Ids (hereinafter, referred to as "driving current") flowing between the first electrode and the second electrode according to a data voltage applied to the gate electrode. The driving current Ids flowing through a channel of the driving transistor DT is proportional to the square of the difference between a threshold voltage and a voltage Vgs between the first electrode and the gate electrode of the driving transistor DT, as shown in Equation (1).

$$[Equation\ 1]$$

$$Ids = k' \times (Vsg\text{-}Vth)^2$$

In Equation (1), k' is a proportional coefficient determined by the structure and physical characteristics of the driving transistor, Vsg is a voltage between the first electrode and the gate electrode of the driving transistor, and Vth is a threshold voltage of the driving transistor.

The light emitting element LEL emits light by the driving current Ids. As the driving current Ids increases, the amount of light emitted from the light emitting element LEL may increase.

The light emitting element LEL may be an organic light emitting diode including an organic light emitting layer disposed between an anode electrode and a cathode electrode. Alternatively, the light emitting element LEL may be an inorganic light emitting element including an inorganic semiconductor disposed between an anode electrode and a cathode electrode. Alternatively, the light emitting element LEL may be a quantum dot light emitting element including a quantum dot light emitting layer disposed between an anode electrode and a cathode electrode. Alternatively, the light emitting element LEL may be a micro light emitting element including a micro light emitting diode disposed between an anode electrode and a cathode electrode.

The anode electrode of the light emitting element LEL may be connected to a first electrode of the fourth transistor ST4 and a second electrode of the sixth transistor ST6, and the cathode electrode of the light emitting element LEL may be connected to the second driving voltage line VSL. A parasitic capacitance Cel may be formed between the anode electrode and the cathode electrode of the light emitting element LEL.

The first transistor ST1 is turned on by the display initialization signal of the $k^{th}$ display initialization line GILk to connect the gate electrode of the driving transistor DT to the third driving voltage line VIL. Accordingly, the third driving voltage VINT of the third driving voltage line VIL may be applied to the gate electrode of the driving transistor DT. The gate electrode of the first transistor ST1 may be connected to the $k^{th}$ display initialization line GILk, the first electrode thereof may be connected to the gate electrode of the driving transistor DT, and the second electrode thereof may be connected to the third driving voltage line VIL.

The second transistor ST2 is turned on by the display write signal of the $k^{th}$ display write line GWLk to connect the first electrode of the driving transistor DT to a $j^{th}$ data line Dj. Accordingly, the data voltage of the $j^{th}$ data line Dj may be applied to the first electrode of the driving transistor DT. The gate electrode of the second transistor ST2 may be connected to the $k^{th}$ display write line GWLk, the first electrode thereof may be connected to the first electrode of the driving transistor DT, and the second electrode thereof may be connected to the $j^{th}$ data line Dj.

The third transistor ST3 is turned on by the display write signal of the $k^{th}$ display write line GWLk to connect the gate electrode of the driving transistor DT to the second electrode thereof. When the gate electrode of the driving transistor DT is connected to the second electrode thereof, the driving transistor DT is driven as a diode. The gate electrode of the third transistor ST3 may be connected to the $k^{th}$ display write line GWLk, the first electrode thereof may be connected to the second electrode of the driving transistor DT, and the second electrode thereof may be connected to the gate electrode of the driving transistor DT.

The fourth transistor ST4 is turned on by the display control signal of the $k^{th}$ display control line GCLk to connect the anode electrode of the light emitting element LEL to the third driving voltage line VIL. The third driving voltage of the third driving voltage line VIL may be applied to the anode electrode of the light emitting element LEL. The gate electrode of the fourth transistor ST4 is connected to the $k^{th}$ display control line GCLk, the first electrode thereof is connected to the anode electrode of the light emitting element LEL, and the second electrode thereof is connected to the third driving voltage line VIL.

The fifth transistor ST5 is turned on by the emission signal of a $k^{th}$ emission line ELk to connect the first electrode of the driving transistor DT to the first driving voltage line VDL. The gate electrode of the fifth transistor ST5 is connected to the $k^{th}$ emission line ELk, the first electrode thereof is connected to the first driving voltage line VDL, and the second electrode thereof is connected to the first electrode of the driving transistor DT.

The sixth transistor ST6 is disposed between the second electrode of the driving transistor DT and the anode electrode of the light emitting element LEL. The sixth transistor ST6 is turned on by the emission control signal of the $k^{th}$ emission line ELk to connect the second electrode of the driving transistor DT to the anode electrode of the light emitting element LEL. The gate electrode of the sixth transistor ST6 is connected to the $k^{th}$ emission line ELk, the first electrode thereof is connected to the second electrode of the driving transistor DT, and the second electrode thereof is connected to the anode electrode of the light emitting element LEL.

When both the fifth transistor ST5 and the sixth transistor ST6 are turned on, the driving current Ids of the driving transistor DT may flow to the light emitting element LEL.

The capacitor CST1 is formed between the gate electrode of the driving transistor DT and the first driving voltage line VDL. The first capacitor electrode of the capacitor CST1 may be connected to the gate electrode of the driving transistor DT, and the second capacitor electrode thereof may be connected to the first driving voltage line VDL.

When the first electrode of each of the driving transistor DT and the first to sixth transistors ST1 to ST6 is a source electrode, the second electrode thereof may be a drain electrode. Alternatively, when the first electrode of each of the driving transistor DT and the first to sixth transistors ST1 to ST6 is a drain electrode, the second electrode thereof may be a source electrode.

An active layer of each of the driving transistor DT and the first to sixth transistors ST1 to ST6 may be formed of any one of polysilicon, amorphous silicon, or an oxide semiconductor. In FIG. 6, the first to sixth transistors ST1 to ST6, and the driving transistor DT have been mainly described as being formed of a P-type MOSFET, but the present disclosure is not limited thereto. For example, the first to sixth transistors ST1 to ST6, and the driving transistor DT may be formed of an N-type MOSFET. Alternatively, at least one of the first to sixth transistors ST1 to ST6 may be formed of an N-type MOSFET.

The light sensing pixel LSP according to one embodiment may be connected to a $p^{th}$ (p being a positive integer) fingerprint scan line FSLp and a $q^{th}$ (q being a positive integer) sensing line RLq. In addition, the display pixel SPX may be connected to the second driving voltage line VSL to which the second driving voltage is supplied.

The light sensing pixel LSP may include the light sensing portion PDU and the fingerprint driver FDU. The light sensing portion PDU may include a light receiving element PD. The fingerprint driver FDU may include a first sensing transistor RT1.

The voltage of a sensing anode electrode of the light receiving element PD may vary depending on light incident on the light receiving element PD. For example, as the amount of light incident on the light receiving element PD increases, the voltage of the sensing anode electrode of the light receiving element PD may increase.

The light receiving element PD may be a photodiode including an anode electrode, a PIN semiconductor layer, and a cathode electrode. The sensing anode electrode of the light receiving element PD may be connected to the first electrode of the first sensing transistor RT1, and the cathode electrode thereof may be connected to the second driving voltage line VSL. The PIN semiconductor layer of the light receiving element PD may include a P-type semiconductor layer connected to the anode electrode, an N-type semiconductor layer connected to the cathode electrode, and an I-type semiconductor layer disposed between the P-type semiconductor layer and the N-type semiconductor layer. In this case, the I-type semiconductor layer is depleted by the P-type semiconductor layer PL and the N-type semiconductor layer NL to generate an electric field therein, and holes and electrons generated by light drift by the electric field. Due to this, the holes may be collected to the anode electrode through the P-type semiconductor layer and the electrons may be collected to the cathode electrode through the N-type semiconductor layer.

The first sensing transistor RT1 is turned on by the fingerprint scan signal of the $p^{th}$ fingerprint scan line FSLp to connect the sensing anode electrode of the light receiving element PD to the $q^{th}$ sensing line RLq. Accordingly, the voltage of the sensing anode electrode of the light receiving element PD may be applied to the $q^{th}$ sensing line RLq. The gate electrode of the first sensing transistor RT1 may be connected to the $p^{th}$ fingerprint scan line FSLp, the first electrode thereof may be connected to the sensing anode electrode of the light receiving element PD, and the second electrode thereof may be connected to the $q^{th}$ sensing line RLq.

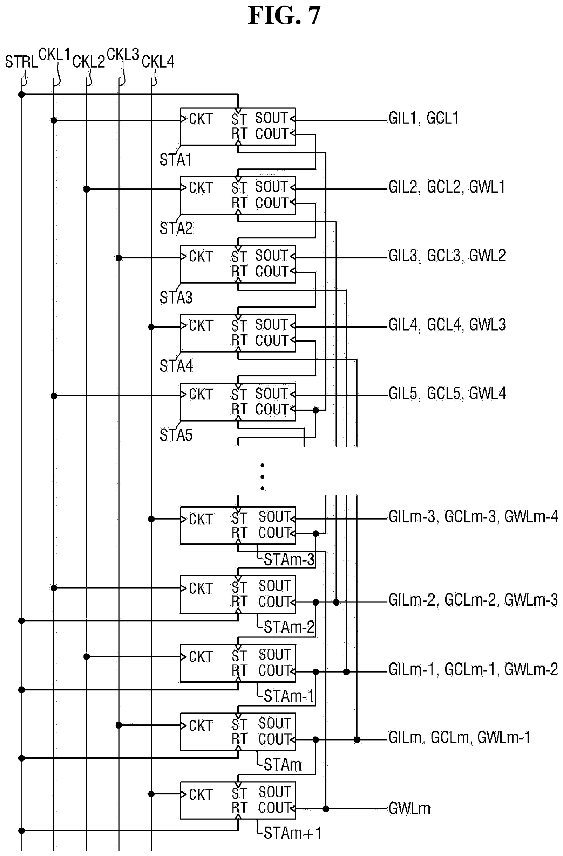

FIG. 7 is an exemplary diagram illustrating a display signal output unit of a display scan driver according to one embodiment.

Referring to FIG. 7, the display signal output unit of the display scan driver 110 may include a plurality of display stages STA1, STA2, STA3, STA4, ..., STAm-1, STAm, and STAm+1 (m being a positive integer). Each of the plurality of display stages STA1 to STAm+1 may include a start signal input terminal ST, a reset signal input terminal RT, a clock signal input terminal CKT, a display signal output terminal SOUT, and a carry signal output terminal COUT.

The start signal input terminal ST of each of the plurality of display stages STA1 to STAm+1 may be connected to a start line STRL or the carry signal output terminal COUT of a previous display stage. For example, the start signal input terminal ST of a first display stage STA1 may be connected to the start line STRL to which a display start signal is inputted. In addition, the start signal input terminal ST of each of the plurality of display stages STA2 to STAm+1 excluding the first display stage STA1 may be connected to the carry signal output terminal COUT of a previous display stage. For example, the start signal input terminal ST of a second display stage STA2 may be connected to the carry signal output terminal COUT of the first display stage STA1, and the start signal input terminal ST of a third display stage STA3 may be connected to the carry signal output terminal COUT of the second display stage STA2.

The reset signal input terminal RT of each of the plurality of display stages STA1 to STAm+1 may be connected to the carry signal output terminal COUT of a subsequent display stage. For example, the reset signal input terminal RT of the first display stage STA1 may be connected to the carry signal output terminal COUT of a fifth display stage STA5, and the reset signal input terminal RT of the (m-2)$^{th}$ display stage STAm-2 is connected to the start line STR.

The clock signal input terminal CKT of each of the plurality of display stages STA1 to STAm+1 may be connected to one of clock lines CKL1, CKL2, CKL3, and CKL4.

The plurality of display stages STA1 to STAm+1 may be alternately connected to the clock lines CKL1 to CKL4. For example, the clock signal input terminal CKT of the first display stage STA1 may be connected to a first clock line CKL1, and the clock signal input terminal CKT of the second display stage STA2 may be connected to a second clock line CKL2. The clock signal input terminal CKT of the third display stage STA3 may be connected to a third clock line CKL3, and the clock signal input terminal CKT of a fourth display stage STA4 may be connected to a fourth clock line CKL4, and the clock signal input terminal CKT of the fifth display stage STA5 is connected to a first clock line CKL1.

The scan signal output terminal SOUT of each of the plurality of display stages STA1 to STAm+1 may be connected to the display write line, the display initialization line, and the display control line corresponding thereto. For example, the first display stage STA1 may be connected to a first display initialization line GIL1 and a first display control line GCL1. In addition, the second display stage STA2 may be connected to a second display initialization line GIL2, a second display control line GCL2, and a first display write line GWL1. In addition, the third display stage STA3 may be connected to a third display initialization line GIL3, a third display control line GCL3, and a second display write line GWL2. In addition, the fourth display stage STA4 may be connected to a fourth display initialization line GIL4, a fourth display control line GCL4, and a third display write line GWL3. In addition, an (m-1)$^{th}$ display stage STAm-1 may be connected to an (m-1)$^{th}$ display initialization line GILm-1, an (m-1)$^{th}$ display control line GCLm-1, and an (m-2)$^{th}$ display write line GWLm-2. In addition, an m$^{th}$ display stage STAm may be connected to an m$^{th}$ display initialization line GILm, an m$^{th}$ display control line GCLm, and an (m-1)$^{th}$ display write line GWLm-1. Further, an (m+1)$^{th}$ display stage STAm+1 may be connected to an m$^{th}$ display write line GWLm.

The carry signal output terminal COUT of each of the plurality of display stages STA1 to STAm+1 may be connected to the reset signal input terminal RT of a previous display stage and the start signal input terminal ST of a subsequent display stage. However, the carry signal output terminal COUT of each of the first display stage STA1, the second display stage STA2, the third display stage STA3, and the fourth display stage STA4 may be connected only to the start signal input terminal ST of a subsequent display stage.

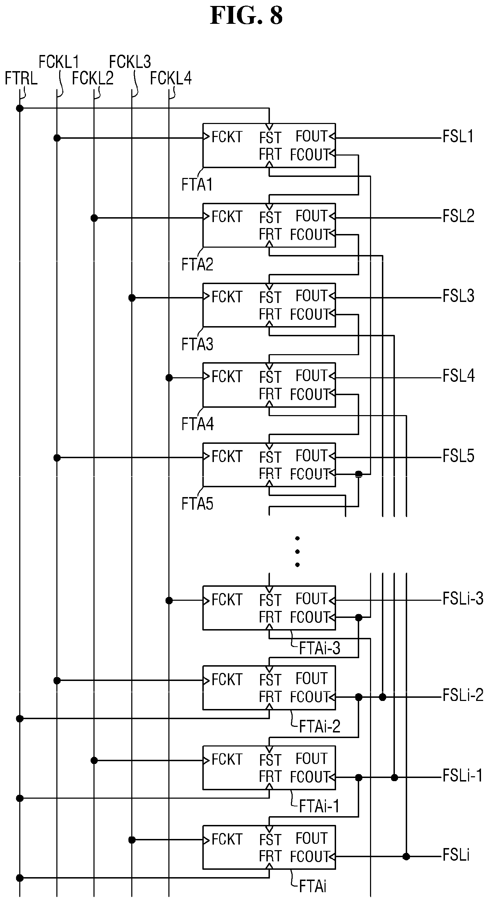

FIG. 8 is an exemplary diagram illustrating a fingerprint scan driver according to one embodiment.

Referring to FIG. 8, the fingerprint scan driver 120 may include a plurality of fingerprint stages FTA1, FTA2, FTA3, FTA4, ..., FTAi-1, and FTAi (i being an integer less than m). Each of the plurality of fingerprint stages FTA1 to FTAi may include a fingerprint start signal input terminal FST, a fingerprint reset signal input terminal FRT, a fingerprint clock signal input terminal FCKT, a fingerprint scan signal output terminal FOUT, and a fingerprint carry signal output terminal FCOUT.

The fingerprint start signal input terminal FST of each of the plurality of fingerprint stages FTA1 to FTAi may be connected to a fingerprint start line FTRL or the fingerprint carry signal output terminal FCOUT of a previous fingerprint stage. For example, the fingerprint start signal input terminal FST of a first fingerprint stage FTA1 may be connected to the fingerprint start line FTRL to which a fingerprint start signal is inputted. In addition, the fingerprint start signal input terminal FST of each of the plurality of fingerprint stages FTA2 to FTAi excluding the first fingerprint stage FTA1 may be connected to the fingerprint carry signal output terminal FCOUT of a previous fingerprint stage. For example, the fingerprint start signal input terminal FST of a second fingerprint stage FTA2 may be connected to the fingerprint carry signal output terminal FCOUT of the first fingerprint stage FTA1, and the fingerprint start signal input terminal FST of a third fingerprint stage FTA3 may be connected to the fingerprint carry signal output terminal FCOUT of the second fingerprint stage FTA2.

The fingerprint reset signal input terminal FRT of each of the plurality of fingerprint stages FTA1 to FTAi may be connected to the fingerprint carry signal output terminal FCOUT of a subsequent fingerprint stage. For example, the fingerprint reset signal input terminal FRT of the first fingerprint stage FTA1 may be connected to the fingerprint carry signal output terminal FCOUT of a fifth fingerprint stage FTA5.

The fingerprint clock signal input terminal FCKT of each of the plurality of fingerprint stages FTA1 to FTAi may be connected to one of fingerprint clock lines FCKL1, FCKL2, FCKL3, and FCKL4.

The plurality of fingerprint stages FTA1 to FTAi may be alternately connected to the fingerprint clock lines FCKL1 to FCKL4. For example, the fingerprint clock signal input terminal FCKT of the first fingerprint stage FTA1 may be connected to a first fingerprint clock line FCKL1, and the fingerprint clock signal input terminal FCKT of the second fingerprint stage FTA2 may be connected to a second fingerprint clock line FCKL2. The fingerprint clock signal input terminal FCKT of the third fingerprint stage FTA3 may be connected to a third fingerprint clock line FCKL3, and the fingerprint clock signal input terminal FCKT of a fourth fingerprint stage FTA4 may be connected to a fourth fingerprint clock line FCKL4, and the fingerprint clock signal input terminal FCKT of a fifth fingerprint stage FTA5 is connected to a first fingerprint clock line FCKL1.

The plurality of fingerprint stages FTA1, FTA2, FTA3, FTA4, ..., FTAi-1, and FTAi may be connected to fingerprint scan lines FSL1, FSL2, FSL3, FSL4, ..., FSLi-1, and FSLi. The fingerprint scan signal output terminal FOUT of each of the plurality of fingerprint stages FTA1 to FTAi may be connected to the fingerprint scan line corresponding thereto. For example, the first fingerprint stage FTA1 may be connected to a first fingerprint scan line FSL1, and the second fingerprint stage FTA2 may be connected to a second fingerprint scan line FSL2. In addition, the third fingerprint stage FTA3 may be connected to a third fingerprint scan line FSL3, and the fourth fingerprint stage FTA4 may be connected to a fourth fingerprint scan line FSL4. In addition, an $(i-1)^{th}$ fingerprint stage FTAi-1 may be connected to an $(i-1)^{th}$ fingerprint scan line FSLi-1, and an $i^{th}$ fingerprint stage FTAi may be connected to an $i^{th}$ fingerprint scan line FSLi.

The fingerprint carry signal output terminal FCOUT of each of the plurality of fingerprint stages FTA1 to FTAi may be connected to the fingerprint reset signal input terminal FRT of a previous fingerprint stage and the fingerprint start signal input terminal FST of a subsequent fingerprint stage. However, the fingerprint carry signal output terminal FCOUT of each of the first fingerprint stage FTA1, the second fingerprint stage FTA2, the third fingerprint stage FTA3, and the fourth fingerprint stage FTA4 is connected to the fingerprint start signal input terminal FST of a subsequent fingerprint stage, but not to the fingerprint reset signal input terminal FRT of a previous fingerprint stage.

Meanwhile, the plurality of display stages STA1 to STAm+1 provide the display write signals, the display initialization signals, and the display control signals to the display pixels SPX of the display area DA. The plurality of fingerprint stages FTA1 to FTAi provide the fingerprint scan signals to the fingerprint drivers FDU connected to the light sensing portions PDU of the fingerprint sensing area FSA which is a part of the display area DA. Since the size of the fingerprint sensing area FSA is smaller than the size of the display area DA, the number of the fingerprint scan lines may be smaller than the number of the display write signals, the number of the display initialization signals, and the number of the display control signals. Therefore, the number of the plurality of fingerprint stages FTA1 to FTAi may be smaller than the number of the plurality of display stages STA1 to STAm+1.

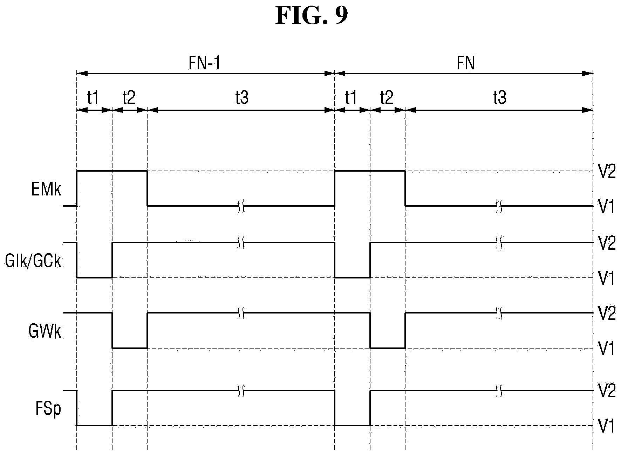

FIG. 9 is a waveform diagram illustrating scan signals inputted to a light sensing pixel and a first display pixel of a display pixel according to one embodiment.

FIG. 9 shows a $k^{th}$ display emission signal EMk applied to the $k^{th}$ emission line ELk, a $k^{th}$ display initialization signal Glk applied to the $k^{th}$ display initialization line GILk, a $k^{th}$ display control signal GCk applied to the $k^{th}$ display control line GCLk, a $k^{th}$ display write signal GWk applied to the $k^{th}$ display write line GWLk, and a $p^{th}$ fingerprint scan signal FSp applied to the $p^{th}$ fingerprint scan line FSLp, durig an $(N-1)^{th}$ frame period FN-1 and an $N^{th}$ frame period FN.

The $k^{th}$ display initialization signal Glk controls on/off of the first transistor ST1 of the display pixel SPX. The $k^{th}$ display control signal GCk controls on/off of the third transistor ST3 of the display pixel SPX. The $k^{th}$ display write signal GWk controls on/off of the second transistor ST2 and the fourth transistor ST4. The $k^{th}$ display emission signal EMk controls on/off of the fifth transistor ST5 and the sixth transistor ST6. The $p^{th}$ fingerprint scan signal FSp controls on/off of the first sensing transistor RT1.

Each of the $(N-1)^{th}$ frame period FN-1 and the $N^{th}$ frame period FN may include a first period t1, a second period t2, and a third period t3. The first period t1 is a period during which the gate electrode of the driving transistor DT is initialized to the third driving voltage VINT. The second period t2 is a period during which a data voltage is supplied to the gate electrode of the driving transistor DT and a threshold voltage of the driving transistor DT is sampled. The third period t3 is a period during which the light emitting element LEL emits light according to the gate voltage of the driving transistor DT. In addition, the first period t1 and the third period t3 are periods during which the light receiving element PD is exposed to light, and the second period t2 is a period during which the anode voltage of the light receiving element PD is detected.

The $k^{th}$ display emission signal EMk has a first level voltage V1 during the third period t3 and a second level voltage V2 during the first period t1 and the second period t2. The $k^{th}$ display write signal GWk has the first level voltage V1 during the second period t2 and the second level voltage V2 during the first period t1 and the third period t3.

The kth display initialization signal Glk and the kth display control signal GCk have the first level voltage V1 during the first period t1, and the second level voltage V2 during the second period t2 and the third period t3. That is, the kth display initialization signal Glk and the kth display control signal GCk may be substantially the same.

The pth fingerprint scan signal FSp has the first level voltage V1 during the first period t1 and the second level voltage V2 during the second period t2 and the third period t3. The pth fingerprint scan signal FSp may be substantially the same as the kth display initialization signal Glk.

Each of the first period t1 and the second period t2 may be one horizontal period. One horizontal period indicates a period during which a data voltage is supplied to each of the display pixels SPX disposed in one horizontal line of the display panel 100, and thus may be defined as one horizontal line scan period. The display pixels SPX arranged in one horizontal line may be defined as sub-pixels connected to one display initialization line, one display write line, one display control line, and one emission line.

The first level voltage V1 may be a turn-on voltage capable of turning on the first to sixth transistors ST1 to ST6 and the first sensing transistor RT1. The second level voltage V2 may be a turn-off voltage capable of turning off the first to sixth transistors ST1 to ST6 and the first sensing transistor RT1. The second level voltage V2 may have a level higher than that of the first level voltage V1.

Hereinafter, the operation of the display pixel SPX during the first period t1, the second period t2, and the third period t3 will be described with reference to FIGS. 6 and 9.

Firstly, in the first period t1, the kth display initialization signal Glk having the first level voltage V1 is supplied to the kth display initialization line GILk, and the kth display control signal GCk having the first level voltage V1 is supplied to the kth display control line GCLk.

During the first period t1, the first transistor ST1 is turned on by the kth display initialization signal Glk having the first level voltage V1. Due to the turn-on of the first transistor ST1, the third driving voltage VINT of the third driving voltage line VIL is applied to the gate electrode of the driving transistor DT. When the third driving voltage VINT is applied to the gate electrode of the driving transistor DT during the first period t1, the voltage Vsg between the first electrode and the gate electrode of the driving transistor DT is greater than the threshold voltage Vth of the driving transistor DT, so that the driving transistor DT may be turned on. That is, since an on bias may be applied to the driving transistor DT, the hysteresis characteristic of the driving transistor DT may be improved.

In addition, during the first period t1, the fourth transistor ST4 is turned on by the kth display control signal GCk having the first level voltage V1. Therefore, due to the turn-on of the fourth transistor ST4 during the first period t1, the anode electrode of the light emitting element LEL may be initialized to the third driving voltage VINT of the third driving voltage line VIL.

Secondly, during the second period t2, the kth display write signal GWk having the first level voltage V1 is supplied to the kth display write line GWLk. Therefore, during the second period t2, each of the second transistor ST2 and the third transistor ST3 is turned on by the kth display write signal GWk having the first level voltage V1.

Due to the turn-on of the third transistor ST3 during the second period t2, the gate electrode and the second electrode of the driving transistor DT are connected to each other, and the driving transistor DT is driven as a diode. In addition, due to the turn-on of the second transistor ST2 during the second period t2, a data voltage Vdata is supplied to the first electrode of the driving transistor DT. In this case, since the voltage Vsg (=Vdata-VINT) between the first electrode and the gate electrode of the driving transistor DT is less than the threshold voltage Vth, the driving transistor DT forms a current path until the voltage Vsg between the first electrode and the gate electrode reaches the threshold voltage Vth. For this reason, during the second period t2, the gate electrode and the second electrode of the driving transistor DT rise to a difference voltage Vdata-Vth between the data voltage Vdata and the threshold voltage Vth of the driving transistor DT.

Thirdly, the kth emission signal EMk having the first level voltage V1 is supplied to the kth emission line ELk during the third period t3. During the third period t3, each of the fifth transistor ST5 and the sixth transistor ST6 is turned on by the kth emission signal EMk having the first level voltage V1.

Due to the turn-on of the fifth transistor ST5, the first electrode of the driving transistor DT is connected to the first driving voltage line VDL. Due to the turn-on of the sixth transistor ST6, the second electrode of the driving transistor DT is connected to the anode electrode of the light emitting element LEL.

When the fifth transistor ST5 and the sixth transistor ST6 are turned on, the driving current Ids flowing according to the voltage of the gate electrode of the driving transistor DT may be supplied to the light emitting element LEL. The driving current Ids may be defined as in Equation (2).

[Equation 2]

$$Ids = k' \times \{VDD\text{-}(Vdata\text{-}Vth)\text{-}Vth\}^2$$

In Equation (2), k' is a proportional coefficient determined by the structure and physical characteristics of the driving transistor DT, Vth is the threshold voltage of the driving transistor DT, VDD is the first driving voltage of the first driving voltage line VDL, and Vdata is the data voltage. The voltage of the gate electrode of the driving transistor DT is Vdata-Vth, and the voltage of the first electrode thereof is VDD. When Equation (2) is summarized, Equation (3) is derived.

[Equation 3]

$$Ids = k' \times (VDD\text{-}Vdata)^2$$

Consequently, as illustrated in Equation (3), the driving current Ids does not depend on the threshold voltage Vth of the driving transistor DT. That is, the threshold voltage Vth of the driving transistor DT may be compensated.

Hereinafter, the operation of the light sensing pixel LSP during the first period t1, the second period t2, and the third period t3 will be described with reference to FIGS. 6 and 9.

Firstly, the $p^{th}$ fingerprint scan signal FSp having the first level voltage V1 is supplied to the $p^{th}$ fingerprint scan line FSLp during the first period t1. The first sensing transistor RT1 is turned on by the $p^{th}$ fingerprint scan signal FSp having the first level voltage V1. Due to the turn-on of the first sensing transistor RT1, the sensing anode electrode of the light receiving element PD may be connected to the $q^{th}$ sensing line RLq. Therefore, the fingerprint driving circuit 400 may detect the voltage of the sensing anode electrode of the light receiving element PD through the $q^{th}$ sensing line RLq.

Secondly, the $p^{th}$ fingerprint scan signal FSp having the second level voltage V2 is supplied to the $p^{th}$ fingerprint scan line FSLp during the second period t2 and the third period t3. Therefore, the first sensing transistor RT1 may be turned off during the second period t2 and the third period t3. Accordingly, the voltage of the sensing anode electrode of the light receiving element PD may increase according to light incident during the second period t2 and the third period t3. For example, as the amount of light incident on the light receiving element PD increases, the voltage of the sensing anode electrode of the light receiving element PD may increase.

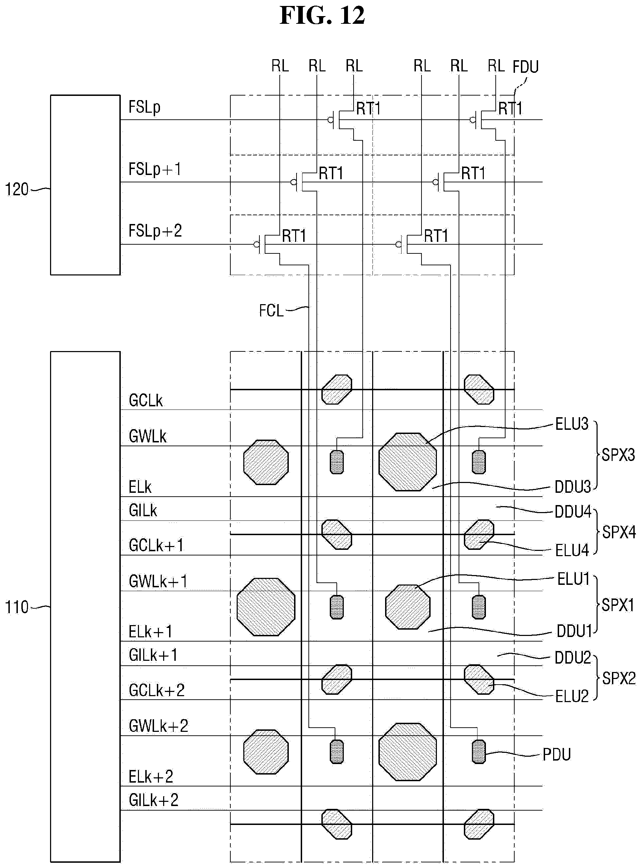

As shown in FIG. 9, the $k^{th}$ display initialization signal Glk and the $p^{th}$ fingerprint scan signal FSp may be substantially the same. To this end, the plurality of fingerprint stages FTA1 to FTAi shown in FIG. 8 may be driven at substantially the same timing as some of the plurality of display stages STA1 to STAm+1 shown in FIG. 7. That is, the plurality of fingerprint stages FTA1 to FTAi may be driven at substantially the same timing as $r^{th}$ (r being an integer less than m) to $s^{th}$ (s being an integer greater than r and less than or equal to m) display stages of the plurality of display stages STA1 to STAm+1. A description thereof will be given later with reference to FIG. 12.

In addition, a fingerprint start signal inputted to the fingerprint start signal input terminal FST of the first fingerprint stage FTA1 may be substantially the same as a carry signal of a previous stage inputted to the start signal input terminal ST of the $r^{th}$ display stage. In addition, fingerprint clock signals applied to the fingerprint clock lines FCKL1, FCKL2, FCKL3 and FCKL4 may be substantially the same as display clock signals applied to the display clock lines CKL1, CKL2, CKL3 and CKL4.

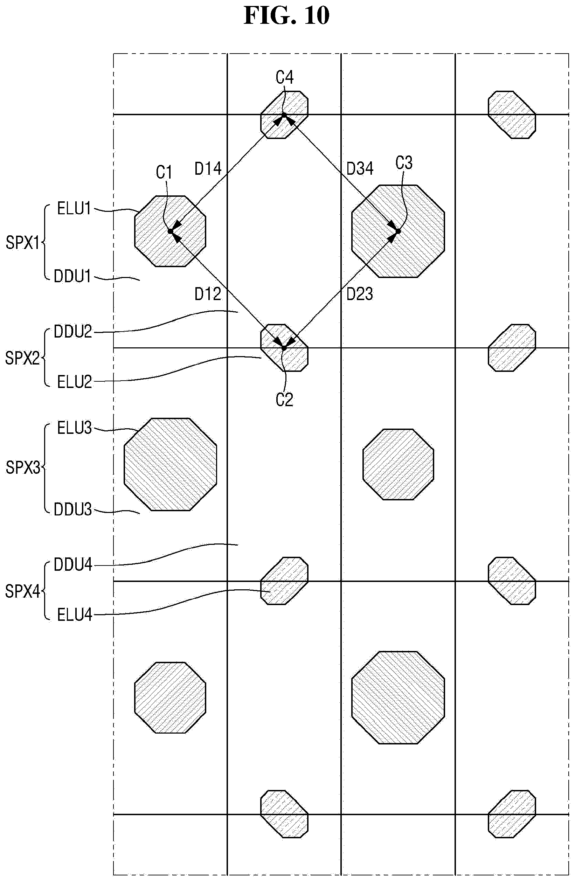

FIG. 10 is a layout diagram illustrating an image display area according to one embodiment.

Referring to FIG. 10, the display area DA may include first display pixels SPX1, second display pixels SPX2, third display pixels SPX3, and fourth display pixels SPX4. The display pixels SPX may be divided into the first display pixels SPX1, the second display pixels SPX2, the third display pixels SPX3, and the fourth display pixels SPX4. The first display pixel SPX1, the second display pixel SPX2, the third display pixel SPX3, and the fourth display pixel SPX4 may be defined as a unit display pixel USPX. The unit display pixel USPX may be defined as the smallest unit of display pixels capable of displaying white.

The first display pixel SPX1 may include a first light emitting portion ELU1 that emits first light, and a first pixel driver DDU1 for applying a driving current to the light emitting element of the first light emitting portion ELU1. The first light may be light of a red wavelength band. For example, the main peak wavelength of the first light may be located at approximately 600 nm to 750 nm.

The second display pixel SPX2 may include a second light emitting portion ELU2 that emits second light, and a second pixel driver DDU2 for applying a driving current to the light emitting element of the second light emitting portion ELU2. The second light may be light of a green wavelength band. For example, the main peak wavelength of the second light may be located at approximately 480 nm to 560 nm.

The third display pixel SPX3 may include a third light emitting portion ELU3 that emits third light, and a third pixel driver DDU3 for applying a driving current to the light emitting element of the third light emitting portion ELU3. The third light may be light of a blue wavelength band. For example, the main peak wavelength of the third light may be located at approximately 370 nm to 460 nm.

The fourth display pixel SPX4 may include a fourth light emitting portion ELU2 that emits the second light, and a fourth pixel driver DDU4 for applying a driving current to the light emitting element of the fourth light emitting portion ELU4.

In the unit display pixel USPX, the first pixel driver DDU1 and the second pixel driver DDU2 may be disposed in the first direction DR1, and the third pixel driver DDU3 and the fourth pixel driver DDU4 may be disposed in the first direction DR1. In the unit display pixel USPX, the first pixel driver DDU1 and the third pixel driver DDU3 may be disposed in the second direction DR2, and the second pixel driver DDU2 and the fourth pixel driver DDU4 may be disposed in the second direction DR2.

The first light emitting portion ELU1 may overlap the first pixel driver DDU1, and the third light emitting portion ELU3 may overlap the third pixel driver DDU3. Each of the second light emitting portion ELU2 and the fourth light emitting portion ELU4 may overlap the second pixel driver DDU2 and the fourth pixel driver DDU4. Each of the second light emitting portion ELU2 and the fourth light emitting portion ELU4 may be disposed at a boundary between the second pixel driver DDU2 and the fourth pixel driver DDU4.

The first light emitting portion ELU1, the second light emitting portion ELU2, the third light emitting portion ELU3, and the fourth light emitting portion ELU4 may have an octagonal shape in plan view, but are not limited thereto. The first light emitting portion ELU1, the second light emitting portion ELU2, the third light emitting portion ELU3, and the fourth light emitting portion ELU4 may have a quadrangular shape such as a rhombus, or another polygonal shape other than a quadrangle and an octagon in plan view.

Due to the arrangement position and planar shape of the first light emitting portion ELU1, the second light emitting portion ELU2, the third light emitting portion ELU3, and the fourth light emitting portion ELU4, a distance D12 between a center C1 of the first light emitting portion ELU1 and a center C2 of the second light emitting portion ELU2 adjacent to each other, a distance D23 between the center C2 of the second light emitting portion ELU2 and a center C3 of the third light emitting portion ELU3 adjacent to each other, a distance D14 between the center C1 of the first light emitting portion ELU1 and a center C4 of the fourth light emitting portion ELU4, and a distance D34 between the center C3 of the third light emitting portion ELU3 and the center C4 of the fourth light emitting portion ELU4 may be substantially the same.

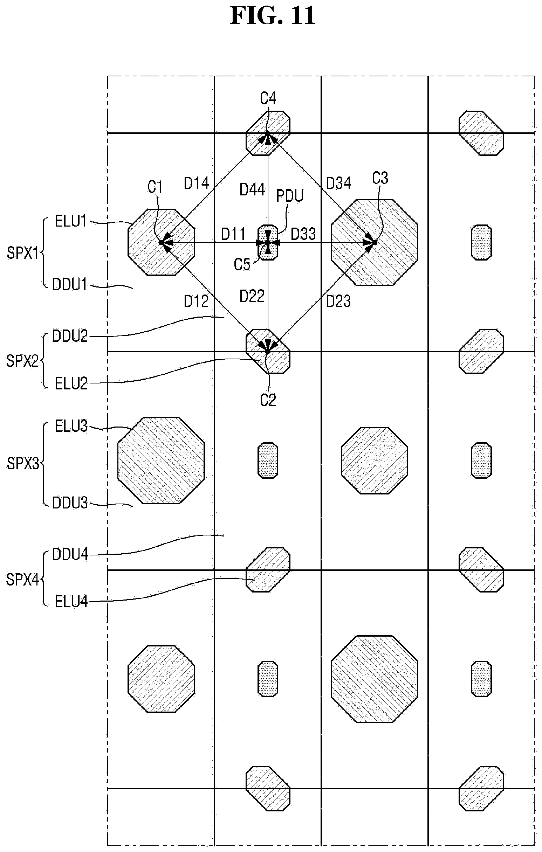

FIG. 11 is a layout diagram illustrating a fingerprint sensing area according to one embodiment.

In FIG. 11, the fingerprint sensing area FSA is different from the image display area IDA shown in FIG. 10 in that it further includes light sensing portions PDU including the light receiving element PD. In FIG. 11, redundant description of parts already described in the embodiment of FIG. 10 will be omitted.

Each of the light sensing portions PDU may be disposed between the first light emitting portion ELU1 and the third light emitting portion ELU3 adjacent in the first direction DR1, and may be disposed between the second light emitting portion ELU2 and the fourth light emitting portion ELU4 adjacent in the second direction DR2.

At least one light sensing portion PDU may be disposed in the unit display pixel USPX. The light sensing portion PDU may overlap the second pixel driver DDU2 or the fourth pixel driver DDU4. Since the second pixel driver DDU2 and the fourth pixel driver DDU4 are alternately disposed in the second direction DR2, the light sensing portion PDU overlapping the second pixel driver DDU2 and the light sensing portion PDU overlapping the fourth pixel driver DDU4 may be alternately disposed in the second direction DR2.

Each of the light sensing portions PDU may have an octagonal shape in plan view, but is not limited thereto. Each of the light sensing portions PDU may have a quadrangular shape such as a rhombus, or another polygonal shape other than a quadrangle and an octagon in plan view.

In addition, due to the arrangement position and planar shape of the first light emitting portion ELU1, the second light emitting portion ELU2, the third light emitting portion ELU3, the fourth light emitting portion ELU4, and the light sensing portion PDU, a distance D11 between the center C1 of the first light emitting portion ELU1 and a center C5 of the light sensing portion PDU adjacent to each other, a distance D22 between the center C2 of the second light emitting portion ELU2 and the center C5 of the light sensing portion PDU adjacent to each other, a distance D33 between the center C3 of the third light emitting portion ELU3 and the center C5 of the light sensing portion PDU adjacent to each other, and a distance D44 between the center C4 of the fourth light emitting portion ELU4 and the center C5 of the light sensing portion PDU adjacent to each other may be substantially the same.

FIG. 12 is an exemplary diagram illustrating light sensing portions of a fingerprint sensing area and fingerprint drivers of a fingerprint driving area according to one embodiment.

For simplicity of description, FIG. 12 illustrates the first to fourth sub-pixels SPX1, SPX2, SPX3, and SPX4 connected to $k^{th}$ to $(k+2)^{th}$ display write lines GWLk, GWLk+1, and GWLk+2, $k^{th}$ to $(k+2)^{th}$ display initialization lines GILk, GILk+1, and GILk+2, $k^{th}$ to $(k+2)^{th}$ display control lines GCLk, GCLk+1, and GCLk+2, and $k^{th}$ to $(k+2)^{th}$ emission lines ELk, ELk+1, and ELk+2, and the fingerprint drivers FDU connected $p^{th}$ to $(p+2)^{th}$ fingerprint scan lines FSLp, FSLp+1, and FSLp+2.

Referring to FIG. 12, the fingerprint driver FDU connected to the $p^{th}$ fingerprint scan line FSLp may be connected to the light sensing portion PDU that overlaps the second pixel driver DDU2 or the fourth pixel driver DDU4 connected to the $k^{th}$ display write line GWLk, the $k^{th}$ display initialization line GILk, the $k^{th}$ display control line GCLk, and the $k^{th}$ emission line ELk. In addition, the fingerprint driver FDU connected to the $(p+1)^{th}$ fingerprint scan line FSLp+1 may be connected to the light sensing portion PDU that overlaps the second pixel driver DDU2 or the fourth pixel driver DDU4 connected to the $(k+1)^{th}$ display write line GWLk+1, the $(k+1)^{th}$ display initialization line GILk+1, and the $(k+1)^{th}$ display control line GCLk+1 and the $(k+1)^{th}$ emission line ELk+1.

Accordingly, the $k^{th}$ display initialization signal applied to the $k^{th}$ display initialization line GILk and the $p^{th}$ fingerprint scan signal applied to the $p^{th}$ fingerprint scan line FSLp may be substantially the same. In addition, a $(k+1)^{th}$ display initialization signal applied to the $(k+1)^{th}$ display initialization line GILk+1 and a $(p+1)^{th}$ fingerprint scan signal applied to the $(p+1)^{th}$ fingerprint scan line FSLp+1 may be substantially the same.

As such, when the $k^{th}$ display initialization signal applied to the $k^{th}$ display initialization line GILk and the $p^{th}$ fingerprint scan signal applied to the $p^{th}$ fingerprint scan line FSLp are substantially the same, an emission period t3 of the first to fourth light emitting portions ELU1 to ELU4 of the sub-pixels SPX1 to SPX4 connected to the $k^{th}$ display initialization line GILk may be set to be substantially equal to a period t3 during which the light receiving elements PD of the light sensing portions PDU adjacent thereto are exposed to light. That is, a period during which light reflected from the user's fingerprint is incident on the light receiving element PD of the light sensing portion PDU may be optimized with an emission period of the first to fourth light emitting portions ELU1 to ELU4 adjacent thereto.

The light receiving elements PD of the light sensing portions PDU and the first sensing transistors RT1 of the fingerprint drivers FDU may be connected one-to-one through sensing connection lines FCL. One end of the sensing connection line FCL may be connected to the sensing anode electrode of the light receiving element PD of the light sensing portion PDU, and the other end of the sensing connection line FCL may be connected to the second electrode of the first sensing transistor RT1 of the fingerprint driver FDU.

The sensing connection line FCL may overlap at least one second pixel driver DDU2 or fourth pixel driver DDU4. In addition, the sensing connection line FCL may overlap the light sensing portion PDU. In addition, when the number of the sensing connection lines FCL increases as the length of the fingerprint sensing area FSA in the second direction DR2 increases, the sensing connection line FCL may overlap the first pixel driver DDU1 or the third pixel driver DDU3.

As shown in FIG. 12, the light receiving elements PD of the light sensing portion PDU are formed in the display area DA together with the light emitting elements LEL of the light emitting portions ELU1, ELU2, ELU3, and ELU4, and are connected one-to-one to the fingerprint drivers FDUs disposed in the non-display area NDA using the sensing connection lines FCL. Accordingly, in order to provide a space in which the fingerprint drivers FDUs are disposed, there is no need to reduce a space in which the first to fourth pixel drivers DDU1 to DDU4 are disposed.

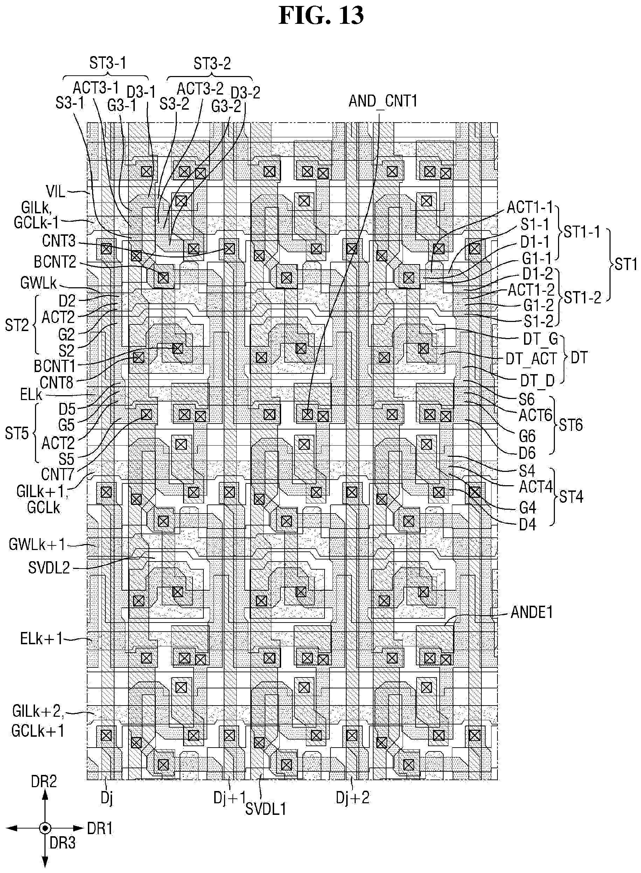

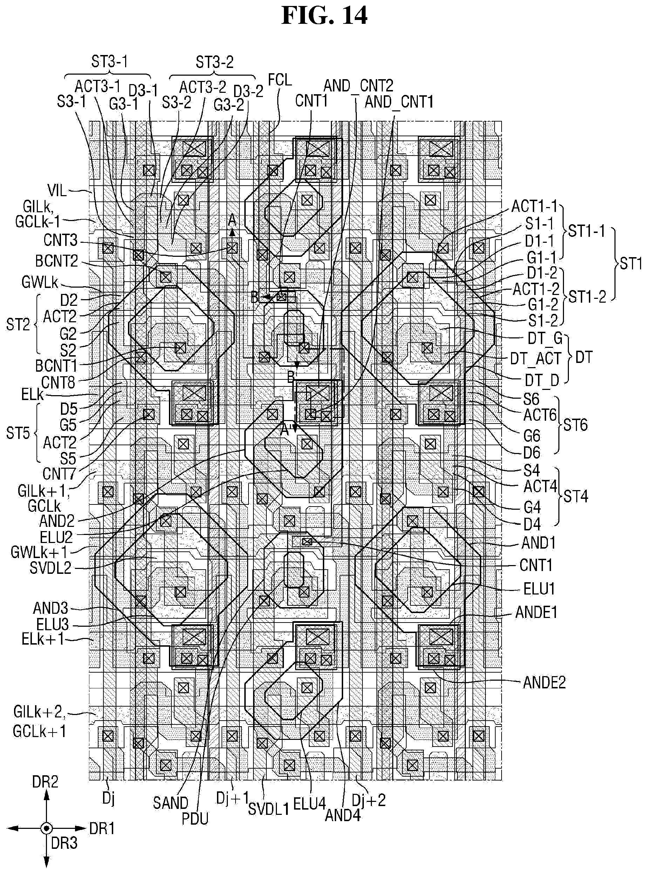

FIGS. 13 and 14 are layout views illustrating area A of FIG. 11 in detail.

For simplicity of description, FIG. 13 illustrates the first pixel drivers PDU1, the second pixel drivers PDU2, the third pixel drivers PDU3, and the fourth pixel drivers PDU4. FIG. 14 illustrates, in addition to those shown in FIG. 13, a first anode electrode AND1, the first light emitting portion ELU1, a second anode electrode AND2, the second light emitting portion ELU2, a third anode electrode AND3, the third light emitting portion ELU3, a fourth anode electrode AND4, the fourth light emitting portion ELU4, the light sensing portion PDU, and the fingerprint connection lines FCL.

Referring to FIGS. 13 and 14, each of the first pixel driver PDU1, the second pixel driver PDU2, the third pixel driver PDU3, and the fourth pixel driver PDU4 may include the driving transistor DT, the first to sixth transistors ST1 to ST6, the capacitor CST1, a first connection electrode BE1, a second connection electrode VIE, a first anode connection electrode ANDE1, and a second anode connection electrode ANDE2.

The $k^{th}$ and $(k+1)^{th}$ display write lines GWLk and GWLk+1, the $k^{th}$ and $(k+1)^{th}$ display initialization lines GILk and GILk+1, the $k^{th}$ and $(k+1)^{th}$ display control lines GCLk and GCLk+1, and the $k^{th}$ and $(k+1)^{th}$ emission lines ELk and ELk+1 may extend in the first direction DR1. The $j^{th}$ to $(j+3)^{th}$ data lines Dj, Dj+1, Dj+2, and Dj+3 may extend in the second direction DR2.

The $(k+1)^{th}$ display initialization line GILk+1 may be substantially the same as the $k^{th}$ display control line GCLk. Similarly, the $k^{th}$ display initialization line GILk may be substantially the same as the $(k-1)^{th}$ display control line, and the $(k+2)^{th}$ display initialization line may be substantially the same as the $(k+1)^{th}$ display control line GCLk.

The first driving voltage line VDL may include a first sub-driving voltage line SVDL1 and a second sub-driving voltage line SVDL2. The first sub-driving voltage line SVDL1 may extend in the second direction DR2, and the second sub-driving voltage line SVDL2 may extend in the first direction DR1. The first sub-driving voltage line SVDL1 may be disposed between each of the $j^{th}$ to $(j+3)^{th}$ data lines Dj, Dj+1, Dj+2, and Dj+3 and the first connection electrode BE1 in the first direction DR1. The second sub-driving voltage line SVDL2 may be disposed between the $k^{th}$ display write line GWLk and the $k^{th}$ emission line ELk, and between the $(k+1)^{th}$ display write line GWLk+1 and the $(k+1)^{th}$ emission line Elk+1 in the second direction DR2. The first sub-driving voltage line SVDL1 may be connected to the second sub-driving voltage line SVDL2 through an eighth contact hole CNT8.

Hereinafter, the first pixel driver DDU1 connected to the $k^{th}$ display write line GWLk will be described in detail. Since the second pixel driver DDU2, the third pixel driver DDU3, and the fourth pixel driver DDU4 connected to the $k^{th}$ display write line GWLk are substantially the same as the first pixel driver DDU1 connected to the $k^{th}$ display write line GWLk, a description thereof will be omitted. In addition, since the first pixel driver DDU1, the second pixel driver DDU2, the third pixel driver DDU3, and the fourth pixel driver DDU4 connected to the $(k+1)^{th}$ display write line GWLk+1 are substantially the same as the first pixel driver DDU1 connected to the $k^{th}$ display write line GWLk, a description thereof will be omitted.

The driving transistor DT may include a channel region DT_ACT, a gate electrode DT_G, a first electrode DT_S, and a second electrode DT_D. The channel region DT_ACT of the driving transistor DT may overlap the gate electrode DT_G of the driving transistor DT in the third direction DR3. The gate electrode DT_G may be disposed on the channel region DT_ACT of the driving transistor DT.

The gate electrode DT_G may be connected to the first connection electrode BE1 through a first connection contact hole BCNT1. The first connection electrode BE1 may be connected to a second electrode D1-1 of a first-first transistor ST1-1 through a second connection contact hole BCNT2. Since the first connection electrode BE1 extends in the second direction DR2, it may cross the $k^{th}$ display write line GWLk.

The first electrode DT_S of the driving transistor DT may be connected to a first electrode S2 of the second transistor ST2. The second electrode DT_D of the driving transistor DT may be connected to a first electrode S1-2 of the first-second transistor ST1-2 and a first electrode S6 of the sixth transistor ST6.

The first transistor ST1 may be formed as a dual transistor. The first transistor ST1 may consist of the first-first transistor ST1-1 and the first-second transistor ST1-2.

The first-first transistor ST1-1 may include a channel region ACT1-1, a gate electrode G1-1, a first electrode S1-1, and the second electrode D1-1. The gate electrode G1-1 of the first-first transistor ST1-1 is a part of the $k^{th}$ display initialization line GILk, and may be a region where the channel region ACT1-1 of the first-first transistor ST1-1 overlaps the $k^{th}$ display initialization line GILk in the third direction DR3. The first electrode S 1-1 of the first-first transistor ST1-1 may be connected to a second electrode D1-2 of the first-second transistor ST1-2. The second electrode D1-1 of the first-first transistor ST1-1 may be connected to the first connection electrode BE1 through the second connection contact hole BCNT2.

The first-second transistor ST1-2 may include a channel region ACT1-2, a gate electrode G1-2, the first electrode S1-2, and the second electrode D1-2. The gate electrode G1-2 of the first-second transistor ST1-2 is a part of the $k^{th}$ display initialization line GILk, and may be a region where the channel region ACT1-2 of the first-second transistor ST1-2 overlaps the $k^{th}$ display initialization line GILk in the third direction DR3. The first electrode S1-2 of the first-second transistor ST1-2 may be connected to the second electrode DT_D of the driving transistor DT. The second electrode D1-2 of the first-second transistor ST1-2 may be connected to the first electrode S1-1 of the first-first transistor ST1-1.

The second transistor ST2 may include a channel region ACT2, a gate electrode G2, the first electrode S2, and the second electrode D2. The gate electrode G2 of the second transistor ST2 is a part of the $k^{th}$ display write line GWLk, and may be a region where the channel region ACT2 of the second transistor ST2 and the $k^{th}$ display write line GWLk overlap in the third direction DR3. The first electrode S2 of the second transistor ST2 may be connected to the first electrode DT_S of the driving transistor DT. The second electrode D2 of the second transistor ST2 may be connected to the $j^{th}$ data line Dj through a third contact hole CNT3.

The third transistor ST3 may be formed as a dual transistor. The third transistor ST3 may consist of the third-first transistor ST3-1 and the third-second transistor ST3-2.

The third-first transistor ST3-1 may include a channel region ACT3-1, a gate electrode G3-1, a first electrode S3-1, and a second electrode D3-1. The gate electrode G3-1 of the third-first transistor ST3-1 is a part of the $k^{th}$ display control line GCLk, and may be a region where the channel region ACT3-1 of the third-first transistor ST3-1 overlaps the $k^{th}$ display control line GCLk. The first electrode S3-1 of the third-first transistor ST3-1 may be connected to the first connection electrode BE1 through the second connection contact hole BCNT2. The second electrode D3-1 of the third-first transistor ST3-1 may be connected to a first electrode S3-2 of the third-second transistor ST3-2.

The third-second transistor ST3-2 may include a channel region ACT3-2, a gate electrode G3-2, the first electrode S3-2, and a second electrode D3-2. The gate electrode G3-2 of the third-second transistor ST3-2 is a part of the $k^{th}$ display control line GCLk, and may be a region where the channel region ACT3-2 of the third-second transistor ST3-2 overlaps the $k^{th}$ display control line GCLk. The first electrode S3-2 of the third-second transistor ST3-2 may be connected to the second electrode D3-1 of the third-first transistor ST3-1. The second electrode D3-2 of the third-second transistor ST3-2 may be connected to the second connection electrode VIE through a fourth contact hole CNT4.

The fourth transistor ST4 may include a channel region ACT4, a gate electrode G4, a first electrode S4, and a second electrode D4. The gate electrode G4 of the fourth transistor ST4 is a part of the $k^{th}$ display write line GWLk, and may be a region where the channel region ACT4 of the fourth transistor ST4 and the $k^{th}$ display write line GWLk overlap. The first electrode S4 of the fourth transistor ST4 may be connected to a first anode connection electrode ANDE1 through a sixth contact hole CNT6. The second anode connection electrode ANDE2 may be connected to the first anode connection electrode ANDE1 through the first anode contact hole AND_CNT1. The second electrode D4 of the fourth transistor ST4 may be connected to the second connection electrode VIE through the fourth contact hole CNT4. The third driving voltage line VIL may be connected to the second connection electrode VIE through a fifth contact hole CNT5, and the second connection electrode VIE may be connected to the second electrode D3-2 of the third-second transistor ST3-2 and the second electrode D4 of the fourth transistor ST4 through the fourth contact hole CNT4.

The second connection electrode VIE may extend in the second direction DR2 and may be disposed to cross the k$^{th}$ display initialization line GILk.

The fifth transistor ST5 may include a channel region ACT5, a gate electrode G5, a first electrode S5, and a second electrode D5. The gate electrode G5 of the fifth transistor ST5 is a part of the k$^{th}$ emission line ELk, and may be a region where the channel region ACT5 of the fifth transistor ST5 overlaps the k$^{th}$ emission line ELk. The first electrode S5 of the fifth transistor ST5 may be connected to the first sub-driving voltage line SVDL1 through a seventh contact hole CNT7. The second electrode D5 of the fifth transistor ST5 may be connected to the first electrode DT_S of the driving transistor DT.

The sixth transistor ST6 may include a channel region ACT6, a gate electrode G6, a first electrode S6, and a second electrode D6. The gate electrode G6 of the sixth transistor ST6 is a part of the k$^{th}$ emission line ELk, and may be a region where the channel region ACT6 of the sixth transistor ST6 overlaps the k$^{th}$ emission line ELk. The first electrode S6 of the sixth transistor ST6 may be connected to the second electrode DT_D of the driving transistor DT. The second electrode D6 of the sixth transistor ST6 may be connected to a first anode connection electrode ANDE1 through a sixth contact hole CNT6.

A first electrode CE11 of the capacitor CST1 may be a part of the second electrode DT_D of the driving transistor DT, and a second electrode CE12 of the capacitor CST1 may be a part of the second sub-driving voltage line SVDL2 that overlaps the second electrode DT_D of the driving transistor DT in the third direction DR3.

The first light emitting portion ELU1 may include a first light emitting portion ELU1 defined by the first anode electrode AND1 and a bank 180. The area of the first anode electrode AND1 may be greater than the area of the first light emitting portion ELU 1. The first anode electrode AND1 may be connected to the second anode connection electrode ANDE2 of the first pixel driver DDU1 through a second anode contact hole AND_CNT2.

The second light emitting portion ELU2 may include a second light emitting portion ELU2 defined by the second anode electrode AND2 and the bank 180. The area of the second anode electrode AND2 may be greater than the area of the second light emitting portion ELU2. The second anode electrode AND2 may be connected to the second anode connection electrode ANDE2 of the second pixel driver DDU2 through the second anode contact hole AND_CNT2.

The third light emitting portion ELU3 may include a third light emitting portion ELU3 defined by the third anode electrode AND3 and the bank 180. The area of the third anode electrode AND3 may be greater than the area of the third light emitting portion ELU3. The third anode electrode AND3 may be connected to the second anode connection electrode ANDE2 of the third pixel driver DDU3 through the second anode contact hole AND_CNT2.

The fourth light emitting portion ELU4 may include a fourth light emitting portion ELU4 defined by the fourth anode electrode AND4 and the bank 180. The area of the fourth anode electrode AND4 may be greater than the area of the fourth light emitting portion ELU4. The fourth anode electrode AND4 may be connected to the second anode connection electrode ANDE2 of the fourth pixel driver DDU4 through the second anode contact hole AND_CNT2.

Each of the light sensing portions PDU may include a light receiving region SLA defined by a sensing anode electrode SAND and the bank 180. The area of the sensing anode electrode SAND may be greater than the area of the light receiving region SLA. The sensing anode electrode SAND may be connected to any one of the sensing connection lines FCL through a third anode contact hole AND_CNT3.

Each of the sensing connection lines FCL may extend in the second direction DR2. The sensing connection line FCL may not overlap the data lines Dj, Dj+1, Dj+2, and Dj+3 in the third direction DR3 to minimize being affected by the voltage change of the data line. In this case, the sensing connection line FCL may overlap the first driving voltage line VDL in the third direction DR3.

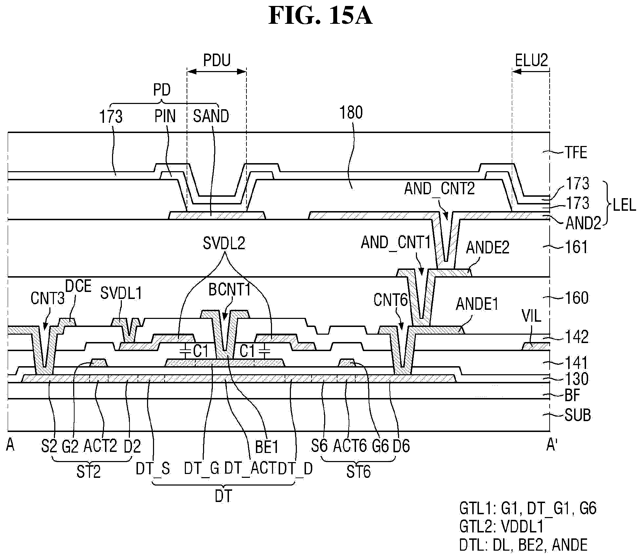

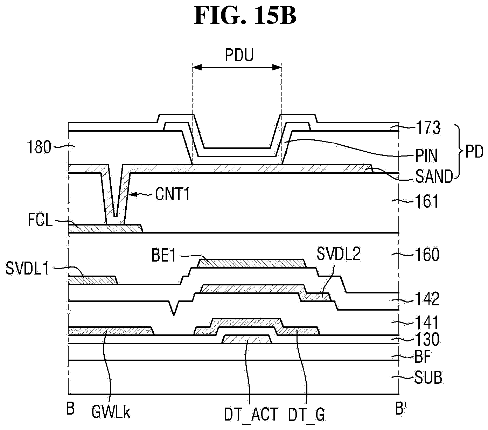

FIGS. 15A and 15B are cross-sectional views illustrating an example of a display panel taken along lines A-A' and B-B' of FIG. 14.

Referring to FIGS. 15A and 15B, a thin film transistor layer TFTL, a light emitting element layer EML, and an encapsulation layer TFE may be sequentially formed on the substrate SUB.

The thin film transistor layer TFTL may be a layer in which the driving transistor DT of each of the first pixel driver DDU1, the second pixel driver DDU2, the third pixel driver DDU3, and the fourth pixel driver DDU4, the first to sixth transistors ST1 to ST6, and the capacitor CST1 are formed. The thin film transistor layer TFTL includes a light blocking layer BML, an active layer ACT, a first gate layer GTL1, a second gate layer GTL2, a first data metal layer DTL1, a second data metal layer DTL2, a buffer layer BF, a gate insulating layer 130, a first interlayer insulating layer 141, a second interlayer insulating layer 142, a first organic layer 160, and a second organic layer 161.

The buffer layer BF may be disposed on one surface of the substrate SUB. The buffer layer BF may be formed on the substrate SUB to protect the thin film transistors and an organic light emitting layer 172 of the light emitting element layer EML from moisture permeating through the substrate SUB susceptible to moisture permeation. The buffer layer BF may be formed of a plurality of inorganic layers that are alternately stacked. For example, the buffer layer BF may be formed of multiple layers in which one or more inorganic layers of a silicon nitride layer, a silicon oxynitride layer, a silicon oxide layer, a titanium oxide layer and an aluminum oxide layer are alternately stacked. The buffer layer BF may be omitted.

The active layer ACT may be formed on the buffer layer BF. The active layer ACT may include polycrystalline silicon, monocrystalline silicon, low-temperature polycrystalline silicon, amorphous silicon, or an oxide semiconductor.

The active layer ACT may include the channel region DT_ACT, the source electrode DT_S, and the drain electrode DT_D of the driving transistor DT. The channel region DT_ACT may overlap the gate electrode DT_G of the driving transistor DT in the third direction DR3 which is the thickness direction of the substrate SUB. The source electrode DT_S may be disposed on one side of the channel region DT_ACT, and the drain electrode DT_D may be disposed on the other side of the channel region DT_ACT. The source electrode DT_S and the drain electrode DT_D may not overlap the gate electrode DT_G in the third direction DR3. The source electrode DT_S and the drain electrode DT_D may have conductivity by doping a silicon semiconductor or an oxide semiconductor with ions or impurities.

In addition, the active layer ACT may include the channel regions ACT1 to ACT6, the source electrodes S1 to S6, and the drain electrodes D1 to D6 of the first to sixth transistors ST1 to ST6. The channel regions ACT1 to ACT6 of the first to sixth transistors ST1 to ST6 may overlap the gate electrodes G1 to G6 corresponding thereto in the third direction DR3, respectively. The source electrodes S1 to S6 and the drain electrodes D1 to D6 of the first to sixth transistors ST1 to ST6 may have conductivity by doping a silicon semiconductor or an oxide semiconductor with ions or impurities.

The gate insulating layer 130 may be formed on the active layer ACT. The gate insulating layer 130 may be formed of an inorganic layer, for example, a silicon nitride layer, a silicon oxynitride layer, a silicon oxide layer, a titanium oxide layer, or an aluminum oxide layer.

The first gate layer GTL1 may be formed on the gate insulating layer 130. The first gate layer GTL1 may include the gate electrode DT_G of the driving transistor DT. In addition, the first gate layer GTL1 may include the gate electrodes G1 to G6 of the first to sixth transistors ST1 to ST6, the display write lines GWLk and GWLk+1, and the display initialization lines GILk and GILk+1, the display control lines GCLk and GCLk+1, and the emission lines ELk and ELk+1. The first gate layer GTL1 may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

The first interlayer insulating layer 141 may be formed on the first gate layer GTL1. The first interlayer insulating layer 141 may be formed of an inorganic layer, for example, a silicon nitride layer, a silicon oxynitride layer, a silicon oxide layer, a titanium oxide layer, or an aluminum oxide layer. The first interlayer insulating layer 141 may include a plurality of inorganic layers.

The second gate layer GTL2 may be formed on the first interlayer insulating layer 141. The second gate layer GTL2 may include the third driving voltage line VIL and the second sub-driving voltage line SVDL2. The second gate layer GTL2 may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

The second interlayer insulating layer 142 may be formed on the second gate layer GTL2. The second interlayer insulating layer 142 may be formed of an inorganic layer, for example, a silicon nitride layer, a silicon oxynitride layer, a silicon oxide layer, a titanium oxide layer, or an aluminum oxide layer. The second interlayer insulating layer 142 may include a plurality of inorganic layers.

The first data metal layer DTL1 may be formed on the second interlayer insulating layer 142. The first data metal layer DTL1 may include the first sub-driving voltage line SVDL1, the first connection electrode BE1, the second connection electrode VIE, and the first anode connection electrode ANDE1. The first data metal layer DTL1 may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

The first organic layer 160 may be formed on the first data metal layer DTL1 to flatten stepped portions caused by the active layer ACT, the first gate layer GTL1, the second gate layer GTL2, and the first data metal layer DTL1. The first organic layer 160 may be formed of an organic layer such as acryl resin, epoxy resin, phenolic resin, polyamide resin, polyimide resin and the like.

The second data metal layer DTL2 may be formed on the first organic layer 160. The second data metal layer DTL2 may include the second anode connection electrode ANDE2 and the sensing connection lines FCL. The second data metal layer DTL2 may be formed as a single layer or multiple layers made of any one of molybdenum (Mo), aluminum (Al), chromium (Cr), gold (Au), titanium (Ti), nickel (Ni), neodymium (Nd) and copper (Cu) or an alloy thereof.

The second organic layer 161 for flattening stepped portions may be formed on the second data metal layer DTL2. The second organic layer 161 may be formed of an organic layer such as acryl resin, epoxy resin, phenolic resin, polyamide resin, polyimide resin and the like.

The first connection contact hole BCNT1 may penetrate the first interlayer insulating layer 141 and the second interlayer insulating layer 142 to expose the gate electrode DT_G of the driving transistor DT. The first connection electrode BE1 may be connected to the gate electrode DT_G of the driving transistor DT through the first connection contact hole BCNT1.

The second connection contact hole BCNT2 may penetrate the gate insulating layer 130, the first interlayer insulating layer 141, and the second interlayer insulating layer 142 to expose the second electrode D1-1 of the first-first transistor ST1-1. The first connection electrode BE1 may be connected to the second electrode D1-1 of the first-first transistor ST1-1 through the second connection contact hole BCNT2.

A first contact hole CNT1 may penetrate the first organic layer 160 to expose the sensing connection line FCL. The sensing anode electrode SAND may be connected to the sensing connection line FCL through the first contact hole CNT1.

The third contact hole CNT3 may penetrate the gate insulating layer 130, the first interlayer insulating layer 141, and the second interlayer insulating layer 142 to expose the second electrode D2 of the second transistor ST2. Each of the data lines Dj, Dj+1, and Dj+2 may be connected to the second electrode D2 of the second transistor ST2 through the third contact hole CNT3.

The fourth contact hole CNT4 may penetrate the gate insulating layer 130, the first interlayer insulating layer 141, and the second interlayer insulating layer 142 to expose the second electrode D1 of the first transistor ST1 and the second electrode D4 of the fourth transistor ST4. The second connection electrode VIE may be connected to the second electrode D1-2 of the first-second transistor ST1-2 and the second electrode D4 of the fourth transistor ST4 through the fourth contact hole CNT4.

The fifth contact hole CNT5 may penetrate the second interlayer insulating layer 142 to expose the third driving voltage line VIL. The second connection electrode VIE may be connected to the third driving voltage line VIL through the fifth contact hole CNT5.

The sixth contact hole CNT6 may penetrate the gate insulating layer 130, the first interlayer insulating layer 141, and the second interlayer insulating layer 142 to expose the second electrode D6 of the sixth transistor ST6. The first anode connection electrode ANDE1 may be connected to the second electrode D6 of the sixth transistor ST6 through the sixth contact hole CNT6.

The seventh contact hole CNT7 may penetrate the gate insulating layer 130, the first interlayer insulating layer 141, and the second interlayer insulating layer 142 to expose the first electrode S5 of the fifth transistor ST5. The first sub-driving voltage line SVDL1 may be connected to the first electrode S5 of the fifth transistor ST5 through the seventh contact hole CNT7.

The eighth contact hole CNT8 may penetrate the second interlayer insulating layer 142 to expose the second sub-driving voltage line SVDL2. The first sub-driving voltage line SVDL1 may be connected to the second sub-driving voltage line SVDL2 through the eighth contact hole CNT8.

A first anode contact hole AND_CNT1 may penetrate the first organic layer 160 to expose the first anode connection electrode ANDE1. The second anode connection electrode ANDE2 may be connected to the first anode connection electrode ANDE1 through the first anode contact hole AND_CNT1.

The second anode contact hole AND_CNT2 may penetrate the second organic layer 161 to expose the second anode connection electrode ANDE2.

The light emitting element layer EML is formed on the thin film transistor layer TFTL. The light emitting element layer EML includes the light emitting elements LEL, the light receiving elements PD, and the bank 180. The light emitting elements LEL, the light receiving elements PD, and the bank 180 are formed on the second organic layer 161.

Each of the light emitting elements LEL may include the anode electrode AND1/AND2/AND3/AND4, the organic light emitting layer 172, and a cathode electrode 173. Each of the light receiving elements PD may include the sensing anode electrode SAND, a PIN semiconductor layer PIN, and the cathode electrode 173.

The light emitting element LEL of the first light emitting portion ELU1 may include the first anode electrode AND1, and the light emitting element LEL of the second light emitting portion ELU2 may include the second anode electrode AND2. The light emitting element LEL of the third light emitting portion ELU3 may include the third anode electrode AND3, and the light emitting element LEL of the fourth light emitting portion ELU4 may include the fourth anode electrode AND4.

The anode electrode AND1/AND2/AND3/AND4 and the sensing anode electrode SAND may be formed on the second organic layer 161. The anode electrode AND1/AND2/AND3/AND4 may be connected to the second anode connection electrode ANDE2 through the second anode contact hole AND_CNT2. The sensing anode electrode SAND may be connected to the sensing connection line FCL through the first contact hole CNT1. The anode electrode AND1/AND2/AND3/AND4 and the sensing anode electrode SAND may be formed of a metal material having high reflectivity such as a stacked structure (Ti/Al/Ti) of aluminum and titanium, a stacked structure (ITO/Al/ITO) of aluminum and ITO, an APC alloy, and a stacked structure (ITO/APC/ITO) of an APC alloy and ITO. The APC alloy is an alloy of silver (Ag), palladium (Pd) and copper (Cu).

The bank 180 may be formed on the second organic layer 161 to partition the anode electrode AND1/AND2/AND3/AND4 and the sensing anode electrode SAND in order to define emission areas EA1, EA2, EA3, and EA4 of the display pixels SPX1, SPX2, SPX3, and SPX4. The bank 180 may be formed to cover the edges of the anode electrode AND1/AND2/AND3/AND4 and the sensing anode electrode SAND. The bank 180 may be formed of an organic layer such as acryl resin, epoxy resin, phenolic resin, polyamide resin, polyimide resin and the like.

In the emission areas EA1, EA2, EA3, and EA4 of the display pixels SPX1, SPX2, SPX3, and SPX4, the anode electrode AND1/AND2/AND3/AND4, the organic light emitting layer 172, and the cathode electrode 173 are sequentially stacked so that holes from the anode electrode AND1/AND2/AND3/AND4 and electrons from the cathode electrode 173 are recombined in the organic light emitting layer 172 to emit light.

The organic light emitting layer 172 is formed on the anode electrode AND1/AND2/AND3/AND4 and the bank 180. The organic light emitting layer 172 may include an organic material to emit light in a predetermined color. For example, the organic light emitting layer 172 may include a hole transporting layer, an organic material layer, and an electron transporting layer. The organic light emitting layer 172 of the first light emitting portion ELU1 may emit the first light, and the organic light emitting layer 172 of the second light emitting portion ELU2 may emit the second light. The organic light emitting layer 172 of the third light emitting portion ELU3 may emit the third light, and the organic light emitting layer 172 of the fourth light emitting portion ELU4 may emit the second light.

Alternatively, when the organic light emitting layer 172 is commonly formed in the emission areas EA1, EA2, EA3, and EA4 of the display pixels SPX1, SPX2, SPX3, and SPX4, the first light emitting portion ELU1 may overlap a first color filter through which the first light is transmitted, and the second light emitting portion ELU2 may overlap a second color filter through which the second light is transmitted. In addition, the third light emitting portion ELU3 may overlap a third color filter through which the third light is transmitted, and the fourth light emitting portion ELU4 may overlap the second color filter through which the second light is transmitted.

The sensing anode electrode SAND, the PIN semiconductor layer PIN, and the cathode electrode 173 are sequentially stacked in the light sensing portion PDU. The PIN semiconductor layer may include a P-type semiconductor layer connected to the sensing anode electrode SAND, an N-type semiconductor layer connected to the cathode electrode 173, and an I-type semiconductor layer disposed between the P-type semiconductor layer and the N-type semiconductor layer. In this case, the I-type semiconductor layer is depleted by the P-type semiconductor layer and the N-type semiconductor layer to generate an electric field therein, and holes and electrons generated by light drift by the electric field. Due to this, the holes may be collected to the anode electrode through the P-type semiconductor layer and the electrons may be collected to the cathode electrode through the N-type semiconductor layer.

The cathode electrode 173 may be disposed on the organic light emitting layer 172, the PIN semiconductor layer PIN, and the bank 180. The cathode electrode 173 may be formed to cover the organic light emitting layer 172 and the PIN semiconductor layer PIN. The cathode electrode 173 may be commonly formed in the emission areas EA1, EA2, EA3, and EA4 and the light sensing portion PDU. A capping layer may be formed on the cathode electrode 173.

In the top emission structure, the cathode electrode 173 may be formed of a transparent conductive material (TCO) such as ITO or IZO capable of transmitting light or a semi-transmissive conductive material such as magnesium (Mg), silver (Ag), or an alloy of magnesium (Mg) and silver (Ag). When the cathode electrode 173 is formed of a semi-transmissive conductive material, the light emission efficiency can be increased due to a micro-cavity effect.

The encapsulation layer TFE may be formed on the light emitting element layer EML. The encapsulation layer TFE may include at least one inorganic layer to prevent oxygen or moisture from permeating into the light emitting element layer EML. In addition, the encapsulation layer TFE may include at least one organic layer to protect the light emitting element layer EML from foreign substances such as dust.

As shown in FIGS. 13 to 15B, the light receiving elements PD of the light sensing portions PDU are formed in the light emitting element layer EML together with the light emitting elements LEL of the emission areas EA1, EA2, EA3, and EA4, and are connected one-to-one to the fingerprint drivers FDU disposed in the non-display area NDA using the sensing connection lines FCL disposed on the first organic layer 160. Therefore, there is no need to form the fingerprint drivers FDU in the thin film transistor layer TFTL in which the first to fourth pixel drivers DDU1 to DDU4 are formed. Accordingly, in order to provide a space in which the fingerprint drivers FDUs are disposed, there is no need to reduce a space in which the first to fourth pixel drivers DDU1 to DDU4 are disposed.

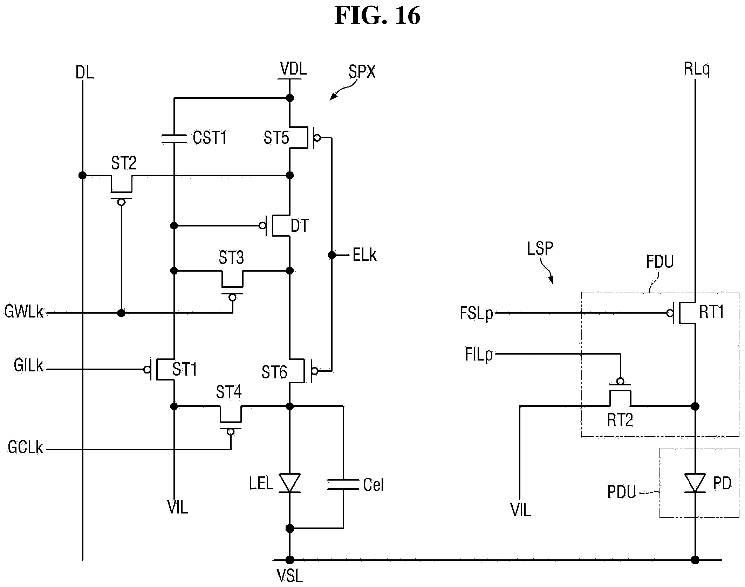

FIG. 16 is a circuit diagram illustrating a light sensing pixel and a first display pixel of a display pixel according to another embodiment.

The embodiment of FIG. 16 is different from the embodiment of FIG. 6 in that the fingerprint driver FDU of the light sensing pixel LSP further includes a second sensing transistor RT2. In FIG. 16, redundant description of parts already described in the embodiment of FIG. 6 will be omitted.

Referring to FIG. 16, the second sensing transistor RT2 is turned on by a fingerprint initialization signal of a $p^{th}$ fingerprint initialization line FILp to connect the sensing anode electrode of the light receiving element PD to the third driving voltage line VIL. Accordingly, the third driving voltage of the third driving voltage line VIL may be applied to the sensing anode electrode of the light receiving element PD. The gate electrode of the second sensing transistor RT2 may be connected to the $p^{th}$ fingerprint initialization line FILp, the first electrode thereof may be connected to the sensing anode electrode of the light receiving element PD, and the second electrode thereof may be connected to the third driving voltage line VIL.

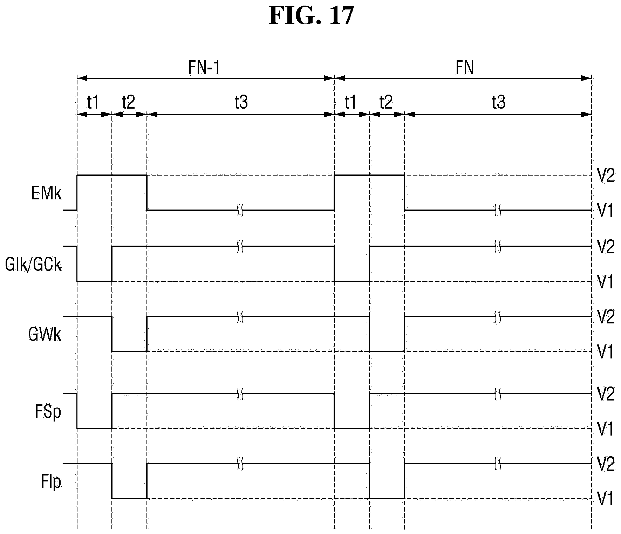

FIG. 17 is a waveform diagram illustrating scan signals inputted to a light sensing pixel and a first display pixel of a display pixel according to still another embodiment.

The embodiment of FIG. 17 is different from the embodiment of FIG. 9 in that a $p^{th}$ fingerprint initialization signal FIp applied to the $p^{th}$ fingerprint initialization line FILp is added. In FIG. 17, redundant description of parts already described in the embodiment of FIG. 9 will be omitted.

Referring to FIG. 17, the $p^{th}$ fingerprint initialization signal FIp has the first level voltage V1 during the second period t2 and the second level voltage V2 during the first period t1 and the third period t3. The $p^{th}$ fingerprint initialization signal FIp may be substantially the same as the $k^{th}$ display write signal GWk or the $k^{th}$ display control signal GCk.

Hereinafter, the operation of the light sensing pixel LSP during the first period t1, the second period t2, and the third period t3 will be described with reference to FIGS. 16 and 17.

Since the operation during the first period t1 is substantially the same as that described with reference to FIGS. 6 and 9, it will be omitted.

During the second period t2, the $p^{th}$ fingerprint initialization signal FIp having the first level voltage V1 is supplied to the $p^{th}$ fingerprint initialization line FILp. The second sensing transistor RT2 is turned on by the $p^{th}$ fingerprint initialization signal FIp having the first level voltage V1. Due to the turn-on of the second sensing transistor RT2, the sensing anode electrode of the light receiving element PD may be connected to the third driving voltage line VIL. Therefore, the sensing anode electrode of the light receiving element PD may be initialized to the third driving voltage of the third driving voltage line VIL.

During the third period t3, the $p^{th}$ fingerprint scan signal FSp having the second level voltage V2 is supplied to the $p^{th}$ fingerprint scan line FSLp, and the $p^{th}$ fingerprint initialization signal FIp having the second level voltage V2 is supplied to the $p^{th}$ fingerprint initialization line FILp. Accordingly, the first sensing transistor RT1 and the second sensing transistor RT2 may be turned off during the third period t3. Accordingly, the voltage of the sensing anode electrode of the light receiving element PD may increase according to light incident during the third period t3. For example, as the amount of light incident on the light receiving element PD increases, the voltage of the sensing anode electrode of the light receiving element PD may increase.

As shown in FIGS. 16 and 17, after exposing the light receiving element PD to light during the third period t3 of the $(N-1)^{th}$ frame period FN-1, the voltage of the sensing anode electrode of the light receiving element PD may be detected through the $q^{th}$ sensing line RLq during the first period t1 of the $N^{th}$ frame period FN. In addition, the voltage of the sensing anode electrode of the light receiving element PD may be initialized to the third driving voltage of the third driving voltage line VIL during the second period t2 of the $N^{th}$ frame period FN. That is, before exposing the light receiving element PD to light, the voltage of the sensing anode electrode of the light receiving element PD may be initialized to the third driving voltage. Therefore, the amount of change in the voltage of the sensing anode electrode of the light receiving element PD depending on the light incident during the third period t3 may be more accurately detected.

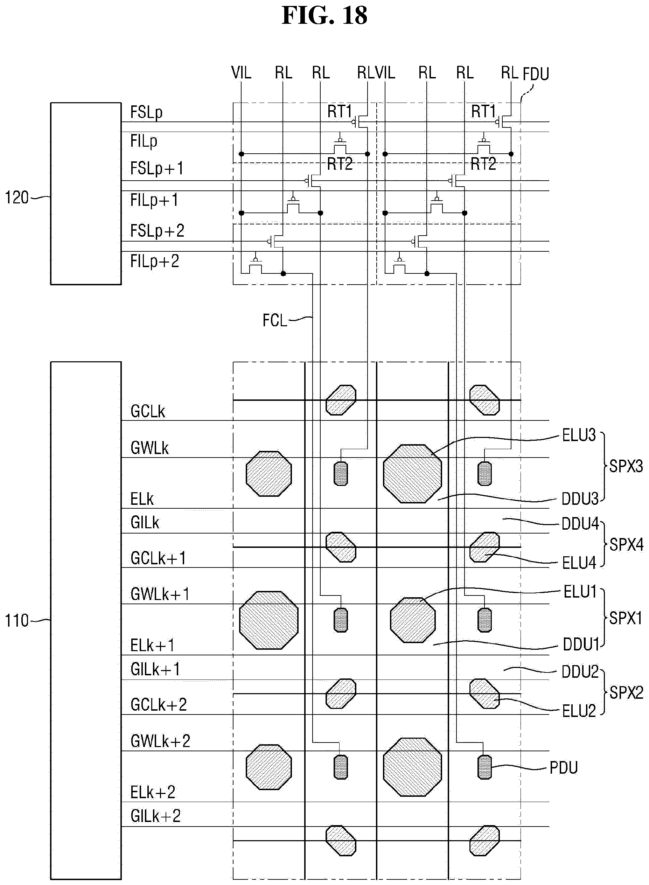

FIG. 18 is an exemplary diagram illustrating light sensing portions of a fingerprint sensing area and fingerprint drivers of a fingerprint driving area according to still another embodiment.

The embodiment of FIG. 18 is different from the embodiment of FIG. 12 in that the fingerprint driver FDU further includes the second sensing transistor RT2 controlled by the $p^{th}$ fingerprint initialization signal FIp of the $p^{th}$ fingerprint initialization line FILp. In FIG. 18, redundant description of parts already described in the embodiment of FIG. 12 will be omitted.

Referring to FIG. 18, the fingerprint driver FDU connected to the $p^{th}$ fingerprint scan line FSLp and the $p^{th}$ fingerprint initialization line FILp may be connected to the light sensing portion PDU that overlaps the second pixel driver DDU2 or the fourth pixel driver DDU4 connected to the $k^{th}$ display write line GWLk, the $k^{th}$ display initialization line GILk, the $k^{th}$ display control line GCLk, and the $k^{th}$ emission line ELk. In addition, the fingerprint driver FDU connected to the $(p+1)^{th}$ fingerprint scan line FSLp+1 and the $(p+1)^{th}$ fingerprint initialization line FILp+1 may be connected to the light sensing portion PDU that overlaps the second pixel driver DDU2 or the fourth pixel driver DDU4 connected to the $(k+1)^{th}$ display write line GWLk+1, the $(k+1)^{th}$ display initialization line GILk+1, the $(k+1)^{th}$ display control line GCLk+1, and the $(k+1)^{th}$ emission line Elk+1.

Accordingly, the $k^{th}$ display write signal applied to the $k^{th}$ display write line GWLk and the $p^{th}$ fingerprint initialization signal applied to the $p^{th}$ fingerprint initialization line FILp may be substantially the same. In addition, the $(k+1)^{th}$ display write signal applied to the $(k+1)^{th}$ display write line GWLk+1 and the $(p+1)^{th}$ fingerprint initialization signal applied to the $(p+1)^{th}$ fingerprint initialization line FILp+1 may be substantially the same.

In addition, the $k^{th}$ display initialization signal applied to the $k^{th}$ display initialization line GILk and the $p^{th}$ fingerprint scan signal applied to the $p^{th}$ fingerprint scan line FSLp may be substantially the same. In addition, the $(k+1)^{th}$ display initialization signal applied to the $(k+1)^{th}$ display initialization line GILk+1 and the $(p+1)^{th}$ fingerprint scan signal applied to the $(p+1)^{th}$ fingerprint scan line FSLp+1 may be substantially the same.

As such, the $k^{th}$ display initialization signal applied to the $k^{th}$ display initialization line GILk and the $p^{th}$ fingerprint scan signal applied to the $p^{th}$ fingerprint scan line FSLp may be substantially the same, and the $k^{th}$ display write signal applied to the $k^{th}$ display write line GWLk and the $p^{th}$ fingerprint initialization signal applied to the $p^{th}$ fingerprint initialization line FILp may be substantially the same. In this case, the emission period t3 of the first to fourth light emitting portions ELU1 to ELU4 of the sub-pixels SPX1 to SPX4 connected to the $k^{th}$ display initialization line GILk and the $k^{th}$ display write line GWLk may be set to be substantially equal to the period t3 during which the light receiving elements PD of the light sensing portions PDU adjacent thereto are exposed to light. That is, a period during which light reflected from the user's fingerprint is incident on the light receiving element PD of the light sensing portion PDU may be optimized with an emission period of the first to fourth light emitting portions ELU1 to ELU4 adjacent thereto.

The light receiving elements PD of the light sensing portions PDU and the second sensing transistors RT2 of the fingerprint drivers FDU may be connected one-to-one through the sensing connection lines FCL. One end of the sensing connection line FCL may be connected to the sensing anode electrode of the light receiving element PD of the light sensing portion PDU, and the other end of the sensing connection line FCL may be connected to the second electrode of the second sensing transistor RT2 of the fingerprint driver FDU.

As in FIG. 18, the light receiving elements PD of the light sensing portions PDU are formed in the display area DA together with the light emitting elements LEL of the emission areas EA1, EA2, EA3, and EA4, and are connected one-to-one to the fingerprint drivers FDU disposed in the non-display area NDA using the sensing connection lines FCL. Accordingly, in order to provide a space in which the fingerprint drivers FDUs are disposed, there is no need to reduce a space in which the first to fourth pixel drivers DDU1 to DDU4 are disposed.

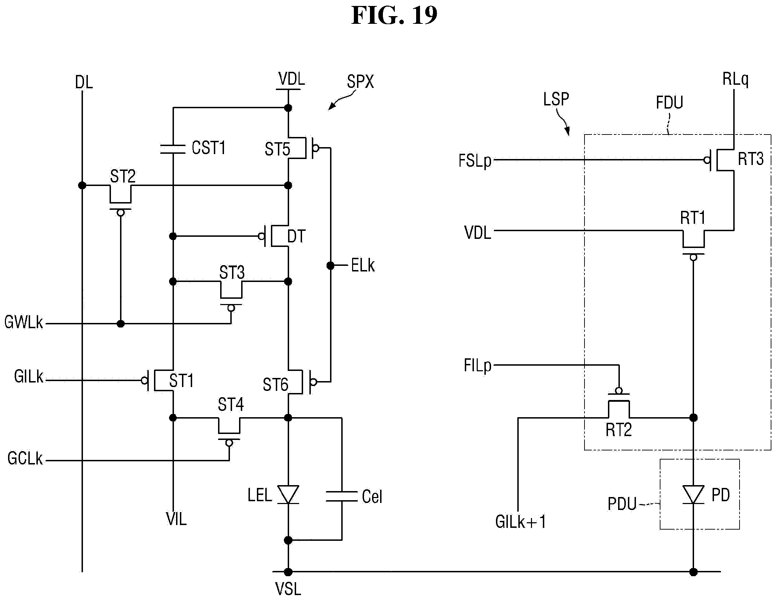

FIG. 19 is a circuit diagram illustrating a light sensing pixel and a first display pixel of a display pixel according to still another embodiment.

The embodiment of FIG. 19 is different from the embodiment of FIG. 6 in that the fingerprint driver FDU of the light sensing pixel LSP further includes first to third sensing transistors RT1, RT2, and RT3. In FIG. 19, redundant description of parts already described in the embodiment of FIG. 6 will be omitted.

Referring to FIG. 19, the first sensing transistor RT1 controls a sensing current flowing from the first driving voltage line VDL to the $q^{th}$ sensing line RLq according to the voltage of the sensing anode electrode of the light receiving element PD. The gate electrode of the first sensing transistor RT1 may be connected to the sensing anode electrode of the light receiving element PD through the sensing connection line FCL, the first electrode thereof may be connected to the first driving voltage line VDL, and the second electrode thereof may be connected to the first electrode of the third sensing transistor RT3.

The second sensing transistor RT2 is turned on by the fingerprint initialization signal of the $p^{th}$ fingerprint initialization line FILp to connect the sensing anode electrode of the light receiving element PD to the $(k+1)^{th}$ display initialization line GILk+1. Accordingly, a $(k+1)^{th}$ display initialization signal GIk+1 of the $(k+1)^{th}$ display initialization line GILk+1 may be applied to the sensing anode electrode of the light receiving element PD. The $(k+1)^{th}$ display initialization signal GIk+1 of the $(k+1)^{th}$ display initialization line GILk+1 may be substantially the same as the $k^{th}$ display write signal GWk of the $k^{th}$ display write line GWLk. The gate electrode of the second sensing transistor RT2 may be connected to the $p^{th}$ fingerprint initialization line FILp, the first electrode thereof may be connected to the sensing anode electrode of the light receiving element PD, and the second electrode thereof may be connected to the $(k+1)^{th}$ display initialization line GILk+1.

The third sensing transistor RT3 is turned on by the fingerprint scan signal of the $p^{th}$ fingerprint scan line FSLp to connect the second electrode of the first sensing transistor RT1 to the $q^{th}$ sensing line RLq. Accordingly, the sensing current according to the voltage of the sensing anode electrode of the light receiving element PD may flow through the $q^{th}$ sensing line RLq, and thus a sensing voltage may be charged in the $q^{th}$ sensing line RLq. That is, the sensing voltage may be charged in the $q^{th}$ sensing line RLq according to the voltage of the sensing anode electrode of the light receiving element PD. The gate electrode of the third sensing transistor RT3 may be connected to the $p^{th}$ fingerprint scan line FSLp, the first electrode thereof may be connected to the second electrode of the first sensing transistor RT1, and the second electrode thereof may be connected to the $q^{th}$ sensing line RLq.

Hereinafter, the operation of the light sensing pixel LSP during the first period t1, the second period t2, and the third period t3 will be described with reference to FIGS. 17 and 19.

During the first period t1, the $p^{th}$ fingerprint scan signal FSp having the first level voltage V1 is supplied to the $p^{th}$ fingerprint scan line FSLp. The third sensing transistor RT3 is turned on by the $p^{th}$ fingerprint scan signal FSp having the first level voltage V1. Due to the turn-on of the third sensing transistor RT3, the sensing current of the first sensing transistor RT1 may flow to the $q^{th}$ sensing line RLq according to the sensing anode electrode of the light receiving element PD. That is, the sensing voltage may be charged in the $q^{th}$ sensing line RLq according to the voltage of the sensing anode electrode of the light receiving element PD. As the voltage of the sensing anode electrode of the light receiving element PD increases, the sensing voltage of the $q^{th}$ sensing line RLq may increase. Therefore, the fingerprint driving circuit 400 may calculate the voltage of the sensing anode electrode of the light receiving element PD by detecting the sensing voltage through the $q^{th}$ sensing line RLq.

During the second period t2, the $p^{th}$ fingerprint initialization signal FIp having the first level voltage V1 is supplied to the $p^{th}$ fingerprint initialization line FILp. The second sensing transistor RT2 is turned on by the $p^{th}$ fingerprint initialization signal FIp having the first level voltage V1. Due to the turn-on of the second sensing transistor RT2, the sensing anode electrode of the light receiving element PD may be connected to the third driving voltage line VIL. Therefore, the sensing anode electrode of the light receiving element PD may be initialized to the third driving voltage of the third driving voltage line VIL.

During the third period t3, the $p^{th}$ fingerprint scan signal FSp having the second level voltage V2 is supplied to the $p^{th}$ fingerprint scan line FSLp, and the $p^{th}$ fingerprint initialization signal FIp having the second level voltage V2 is supplied to the $p^{th}$ fingerprint initialization line FILp. Accordingly, the second sensing transistor RT2 and the third sensing transistor RT3 may be turned off during the third period t3. Accordingly, the voltage of the sensing anode electrode of the light receiving element PD may increase according to light incident during the third period t3. For example, as the amount of light incident on the light receiving element PD increases, the voltage of the sensing anode electrode of the light receiving element PD may increase.

As in FIGS. 17 and 19, after exposing the light receiving element PD to light during the third period t3 of the $(N-1)^{th}$ frame period FN-1, the sensing current of the first sensing transistor RT1 may be made to flow to the $q^{th}$ sensing line RLq according to the sensing anode electrode of the light receiving element PD during the first period t1 of the $N^{th}$ frame period FN, thereby detecting the sensing voltage of the $q^{th}$ sensing line RLq. In addition, the voltage of the sensing anode electrode of the light receiving element PD may be initialized to the third driving voltage of the third driving voltage line VIL during the second period t2 of the $N^{th}$ frame period FN. That is, before exposing the light receiving element PD to light, the voltage of the sensing anode electrode of the light receiving element PD may be initialized to the third driving voltage.

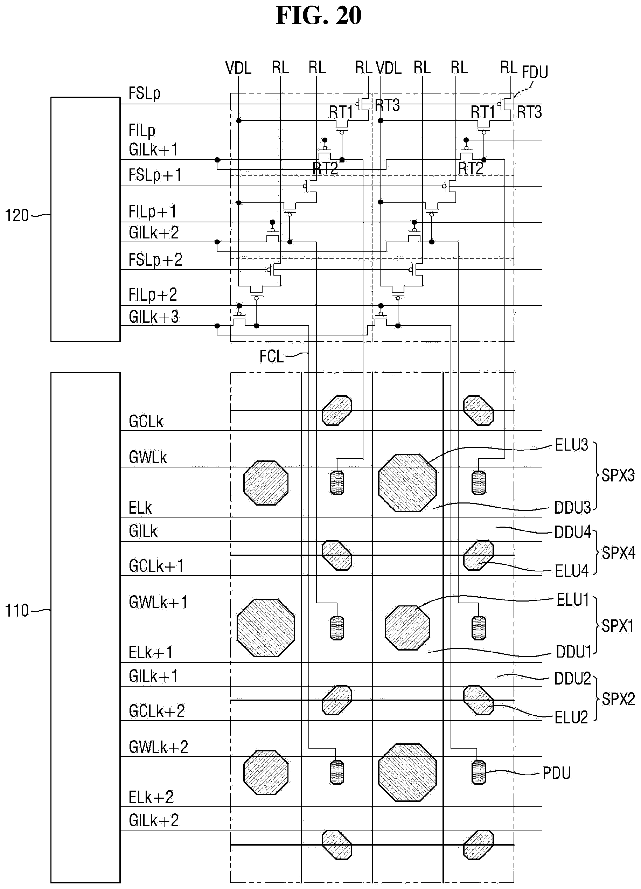

FIG. 20 is an exemplary diagram illustrating light sensing portions of a fingerprint sensing area and fingerprint drivers of a fingerprint driving area according to still another embodiment.

The embodiment of FIG. 20 is different from the embodiment of FIG. 18 only in that the fingerprint driver FDU includes the first to third sensing transistors RT1, RT2, and RT3. Therefore, a description of the embodiment of FIG. 20 will be omitted.

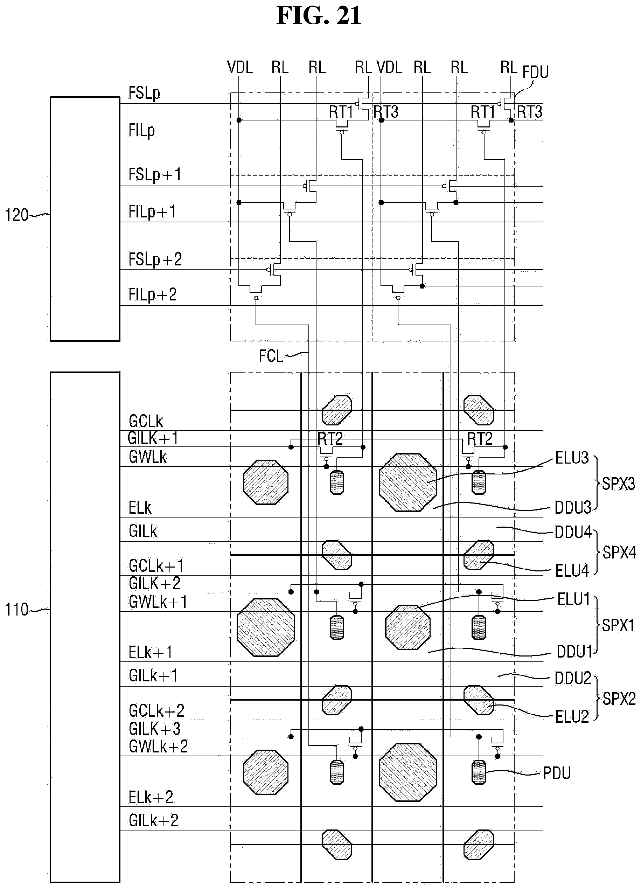

FIG. 21 is an exemplary diagram illustrating light sensing portions of a fingerprint sensing area and fingerprint drivers of a fingerprint driving area according to still another embodiment.

The embodiment of FIG. 21 is different from the embodiment of FIG. 20 in that the second sensing transistor RT2 of the fingerprint driver FDU is disposed in the fingerprint sensing area FSA together with the light sensing portion PDU including the light receiving element PD.

Referring to FIG. 21, when the first to fourth pixel drivers DDU1 to DDU4 are reduced in the fingerprint sensing area FSA, an area where the second sensing transistor RT2 is disposed may be provided. In this case, the second sensing transistor RT2 may be formed similarly to the driving transistor DT or the first to sixth transistors ST1 to ST6 in the thin film transistor layer TFTL.

Although it is illustrated in FIG. 21 that the second sensing transistor RT2 is disposed in the fingerprint sensing area FSA, the embodiment of the present disclosure is not limited thereto. For example, the first sensing transistor RT1 of the fingerprint driver FDU may be disposed in the fingerprint sensing area FSA. Alternatively, the first sensing transistor RT1 and the second sensing transistor RT2 of the fingerprint driver FDU may be disposed in the fingerprint sensing area FSA. Alternatively, the first sensing transistor RT1 and the third sensing transistor RT3 of the fingerprint driver FDU may be disposed in the fingerprint sensing area FSA.

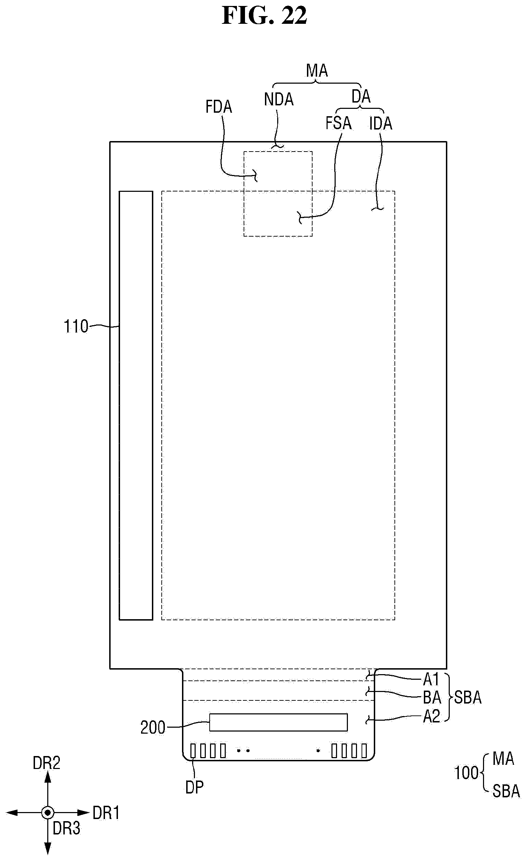

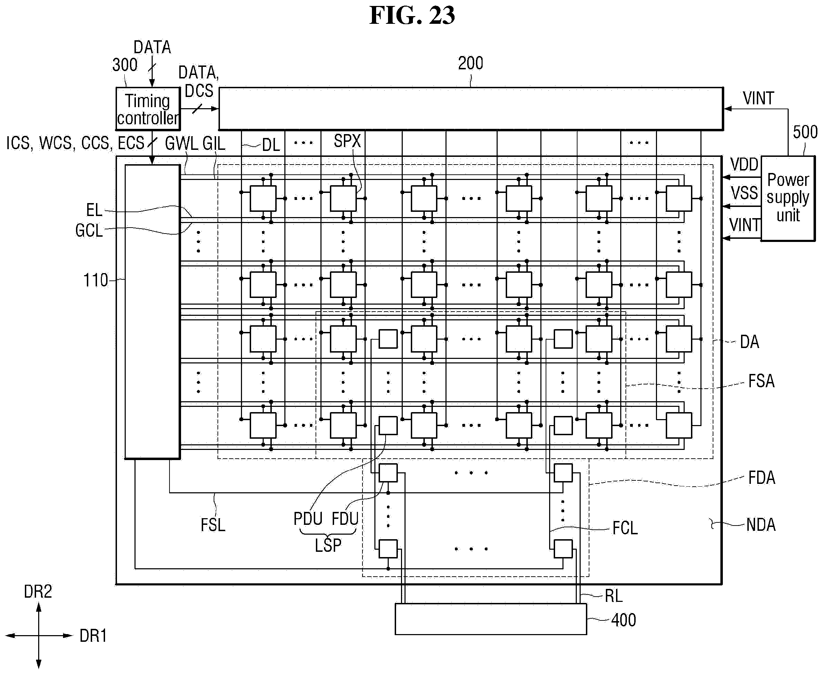

FIG. 22 is a layout diagram illustrating a display panel and a display driving circuit according to still another embodiment. FIG. 23 is a block diagram illustrating a display device according to still another embodiment.

The embodiment of FIGS. 22 and 23 is different from the embodiment of FIGS. 2 and 5 in that the fingerprint scan driver 120 is omitted and the fingerprint driver FDU of the fingerprint driving area FDA is connected to the display scan driver 110. In FIGS. 22 and 23, redundant description of parts already described in the embodiment of FIGS. 2 and 5 will be omitted.

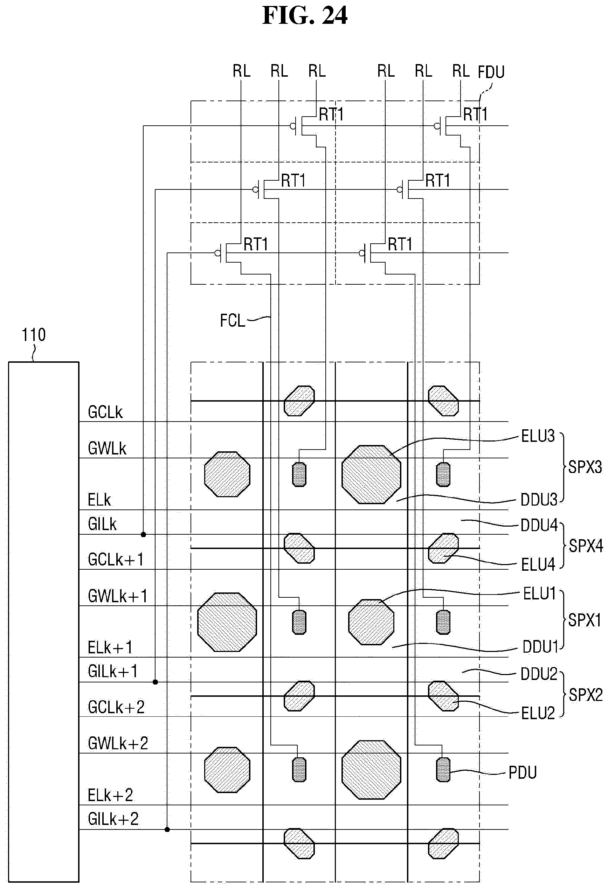

Specifically, when the fingerprint driver FDU includes the first sensing transistor RT1 as shown in FIG. 24, the $p^{th}$ fingerprint scan signal of the $p^{th}$ fingerprint scan line FSLp connected to the gate electrode of the first sensing transistor RT1 may be substantially the same as the $k^{th}$ display initialization signal of the $k^{th}$ display initialization line GILk. Therefore, as shown in FIG. 24, the fingerprint driver FDU may be connected to the $k^{th}$ display initialization line GILk connected to the display scan driver 110, instead of the $p^{th}$ fingerprint scan line FSLp.

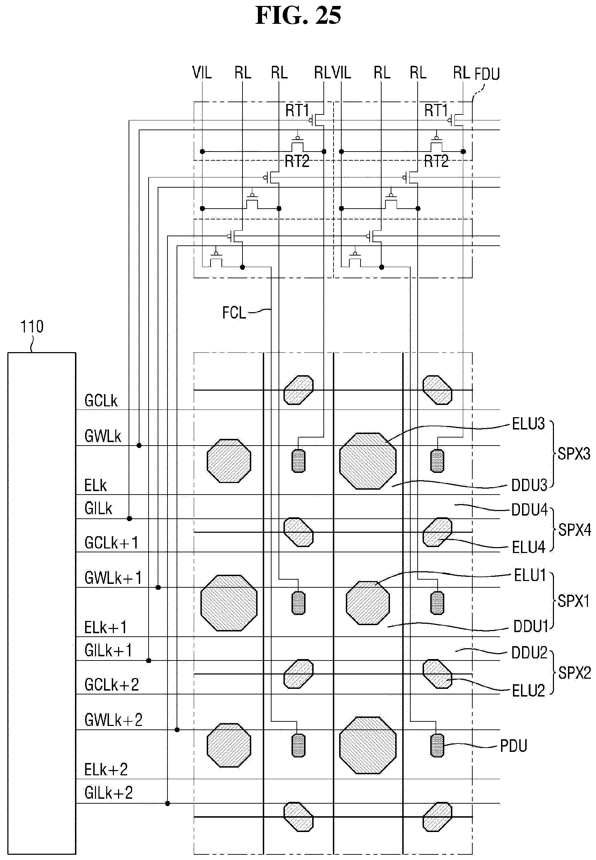

Alternatively, as shown in FIG. 25, the fingerprint driver FDU may include the first sensing transistor RT1 and the second sensing transistor RT2. In this case, the $p^{th}$ fingerprint scan signal of the $p^{th}$ fingerprint scan line FSLp connected to the gate electrode of the first sensing transistor RT1 may be substantially the same as the $k^{th}$ display initialization signal of the $k^{th}$ display initialization line GILk. In addition, the $p^{th}$ fingerprint initialization signal of the $p^{th}$ fingerprint initialization line FSLp connected to the gate electrode of the second sensing transistor RT2 may be substantially the same as the $k^{th}$ display write signal of the $k^{th}$ display write line GWLk. Therefore, as shown in FIG. 25, the fingerprint driver FDU may be connected to the $k^{th}$ display initialization line GILk connected to the display scan driver 110, instead of the $p^{th}$ fingerprint scan line FSLp and the $p^{th}$ fingerprint initialization line FILp.

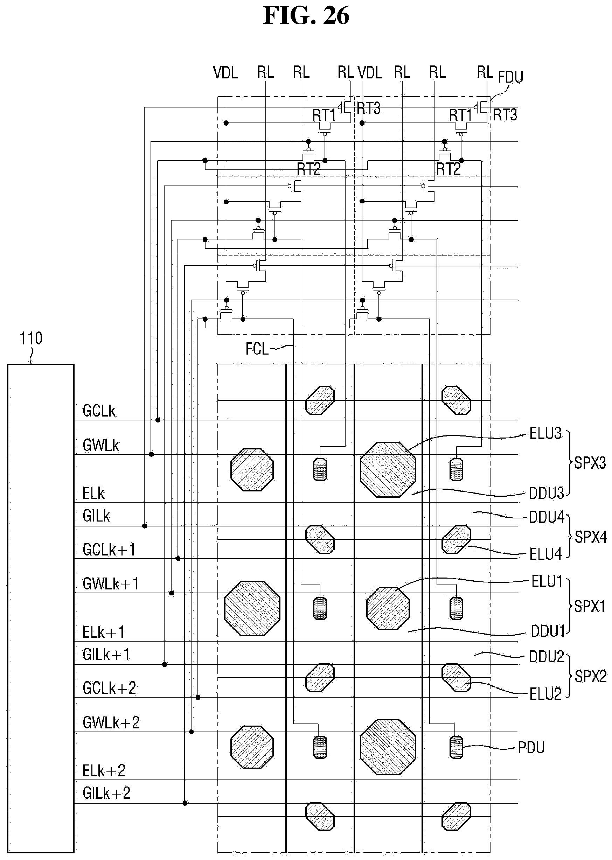

Alternatively, as shown in FIG. 26, the fingerprint driver FDU may include the first sensing transistor RT1, the second sensing transistor RT2, and the third sensing transistor RT3. In this case, the $p^{th}$ fingerprint initialization signal of the $p^{th}$ fingerprint initialization line FSLp connected to the gate electrode of the second sensing transistor RT2 may be substantially the same as the $k^{th}$ display write signal of the $k^{th}$ display write line GWLk. In addition, the $p^{th}$ fingerprint scan signal of the p$^{th}$ fingerprint scan line FSLp connected to the gate electrode of the third sensing transistor RT3 may be substantially the same as the k$^{th}$ display initialization signal of the k$^{th}$ display initialization line GILk. Therefore, as shown in FIG. 26, the fingerprint driver FDU may be connected to the k$^{th}$ display initialization line GILk connected to the display scan driver 110, instead of the p$^{th}$ fingerprint scan line FSLp and the p$^{th}$ fingerprint initialization line FILp.

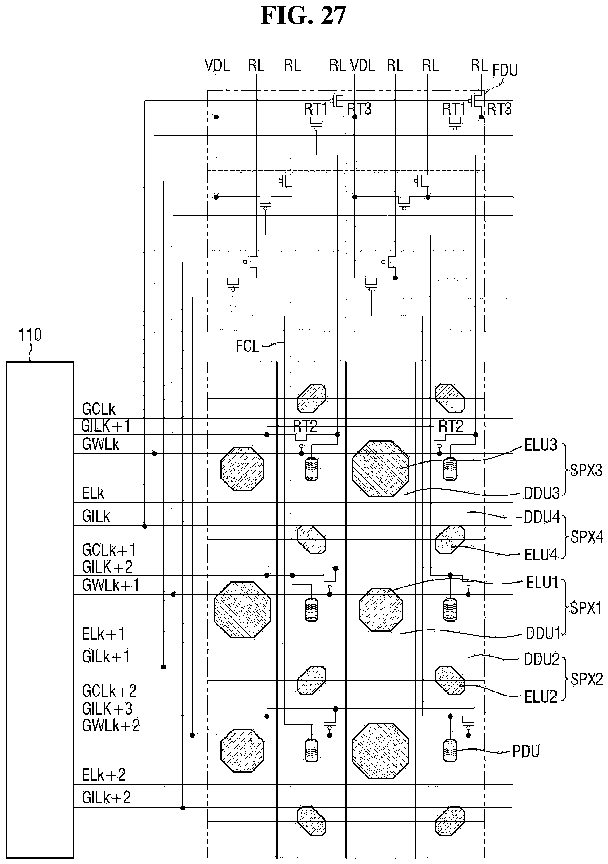

Meanwhile, as shown in FIG. 27, the second sensing transistor RT2 of the fingerprint driver FDU may be disposed in the fingerprint sensing area FSA together with the light sensing portion PDU. When the first to fourth pixel drivers DDU1 to DDU4 are reduced in the fingerprint sensing area FSA, an area where the second sensing transistor RT2 is disposed may be provided. In this case, the second sensing transistor RT2 may be formed similarly to the driving transistor DT or the first to sixth transistors ST1 to ST6 in the thin film transistor layer TFTL.

Although it is illustrated in FIG. 27 that the second sensing transistor RT2 is disposed in the fingerprint sensing area FSA, the embodiment of the present disclosure is not limited thereto. For example, the first sensing transistor RT1 of the fingerprint driver FDU may be disposed in the fingerprint sensing area FSA. Alternatively, the first sensing transistor RT1 and the second sensing transistor RT2 of the fingerprint driver FDU may be disposed in the fingerprint sensing area FSA. Alternatively, the first sensing transistor RT1 and the third sensing transistor RT3 of the fingerprint driver FDU may be disposed in the fingerprint sensing area FSA.

Although embodiments of the present invention have been described above with reference to the attached drawings, those skilled in the art will understand that the present invention can be implemented in other specific forms without changing its technical idea or essential features. You will be able to understand it. Therefore, the embodiments described above should be understood in all respects as illustrative and not restrictive.

**Claims**

1.  A display device comprising:

    a substrate comprising a display area displaying an image and a non-display area disposed around the display area;
    display pixels, each comprising a light emitting element disposed in the display area and a pixel driver connected to the light emitting element; and
    light sensing pixels, each comprising a light receiving element and a fingerprint driver connected to the light receiving element,
    wherein the fingerprint driver comprises at least one transistor, and the light receiving element is disposed in the display area, and the at least one transistor of the fingerprint driver is disposed in the non-display area.

2.  The display device of claim 1, wherein the fingerprint driver is disposed on a first side of the display area.

3.  The display device of claim 2, further comprising:

    a display scan driver disposed in the non-display area and configured to output scan signals to the pixel driver; and
    a fingerprint scan driver disposed in the non-display area and configured to output fingerprint scan signals to the fingerprint driver.

4.  The display device of claim 3, wherein the display scan driver is disposed on a second side of the display area.

5.  The display device of claim 4, wherein the fingerprint scan driver is disposed at a corner where the first side and the second side of the display area meet.

6.  The display device of claim 3, wherein the fingerprint scan driver is disposed on the first side of the display area.

7.  The display device of claim 4, wherein the fingerprint scan driver is disposed at a corner where the first side and the second side of the display area meet and on the first side of the display area.

8.  The display device of claim 1, wherein the pixel driver comprises:

    a driving transistor configured to control a driving current flowing through the light emitting element according to a data voltage applied to a gate electrode;
    a first transistor connected the gate electrode of the driving transistor to a driving voltage line to which a driving voltage is applied according to a display initialization signal;

a second transistor connected a source electrode of the driving transistor to a data line according to a display write signal; and

a third transistor connected an anode electrode of the light emitting element to the driving voltage line according to a display control signal.

9. The display device of claim 8, wherein the fingerprint driver comprises a first sensing transistor connected a fingerprint connection line connected to a light receiving anode electrode of the light receiving element to a sensing line according to a fingerprint scan signal of a fingerprint scan line.

10. The display device of claim 9, wherein the fingerprint scan signal is same as the display initialization signal.

11. The display device of claim 9, wherein the fingerprint scan signal is same as the display control signal.

12. The display device of claim 9, wherein the first sensing transistor is disposed in the non-display area.

13. The display device of claim 9, wherein the fingerprint driver further comprises a second sensing transistor connected the fingerprint connection line to the driving voltage line to which the driving voltage is applied according to a fingerprint initialization signal of a fingerprint initialization line.

14. The display device of claim 13, wherein the second sensing transistor is disposed in the non-display area.

15. The display device of claim 9, wherein the fingerprint initialization signal is same as the display write signal.

16. The display device of claim 8, wherein the fingerprint driver comprises:

a first sensing transistor configured to control a sensing current flowing through a sensing line according to a voltage of a light receiving anode electrode of the light receiving element;

a second optical transistor configured to initialize the light receiving anode electrode according to a fingerprint initialization signal of a fingerprint initialization line; and

a third sensing transistor connected a drain electrode of the first sensing transistor to the sensing line according to a fingerprint scan signal of the fingerprint scan line.

17. The display device of claim 16, wherein the first sensing transistor, the second sensing transistor, and the third sensing transistor are disposed in the non-display area.

18. The display device of claim 16, wherein the first sensing transistor and the third sensing transistor are disposed in the non-display area, and the second sensing transistor is disposed in the display area.

19. The display device of claim 16, wherein the fingerprint scan signal is same as the display initialization signal, and the fingerprint initialization signal is same as the display write signal.

20. A display device comprising:

a substrate comprising a display area displaying an image and a non-display area disposed around the display area; and

light sensing pixels, each comprising a light receiving element and a fingerprint driver connected to the light receiving element,

wherein the fingerprint driver comprises a plurality of transistors,

the light receiving element is disposed in the display area, at least one of the plurality of transistors of the fingerprint driver is disposed in the non-display area, and another one of the plurality of transistors is disposed in the display area.

21. A display device comprising:

a substrate comprising a display area displaying an image and a non-display area disposed around the display area;

display pixels, each comprising a light emitting element disposed in the display area and a pixel driver connected to the light emitting element;

light sensing pixels, each comprising a light receiving element and a fingerprint driver connected to the light receiving element; and

a scan driver disposed in the non-display area and configured to apply scan signals to the pixel driver and apply fingerprint scan signals to the fingerprint driver.

22. The display device of claim 21, wherein the fingerprint driver comprises at least one transistor,
the light receiving element is disposed in the display area, and the at least one transistor of the fingerprint driver is disposed in the non-display area.

# FIG. 1

# FIG. 2

## FIG. 3

# FIG. 4

**FIG. 5**

**FIG. 6**

EP 4 394 755 A1

# FIG. 7

# FIG. 8

# FIG. 9

# FIG. 10

# FIG. 11

# FIG. 12

# FIG. 13

# FIG. 14

## FIG. 15A

GTL1: G1, DT_G1, G6
GTL2: VDDL1
DTL: DL, BE2, ANDE

## FIG. 15B

# FIG. 16

EP 4 394 755 A1

# FIG. 17

# FIG. 18

FIG. 19

EP 4 394 755 A1

# FIG. 20

# FIG. 21

# FIG. 22

**FIG. 23**

# FIG. 24

# FIG. 25

# FIG. 26

FIG. 27

## INTERNATIONAL SEARCH REPORT

| International application No. |
| --- |
| **PCT/KR2022/010673** |

**A. CLASSIFICATION OF SUBJECT MATTER**

**G09G 3/3225**(2016.01)i; **G09G 3/3266**(2016.01)i; **H01L 27/32**(2006.01)i; **G06V 40/13**(2022.01)i; **G06F 3/041**(2006.01)i

According to International Patent Classification (IPC) or to both national classification and IPC

**B. FIELDS SEARCHED**

Minimum documentation searched (classification system followed by classification symbols)

G09G 3/3225(2016.01); G02B 5/20(2006.01); G06F 3/041(2006.01); G06F 3/044(2006.01); G06K 9/00(2006.01); G09G 3/20(2006.01); H01L 27/12(2006.01); H01L 27/32(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 비표시 영역(non-display area), 표시 화소(display pixel), 광감지 화소(light detection pixel), 트랜지스터(transistor), 수광 소자(light receiving element), 표시 장치(display device)

**C. DOCUMENTS CONSIDERED TO BE RELEVANT**

| Category* | Citation of document, with indication, where appropriate, of the relevant passages | Relevant to claim No. |
| --- | --- | --- |
| Y | KR 10-2021-0086907 A (SAMSUNG DISPLAY CO., LTD.) 09 July 2021 (2021-07-09)<br>See paragraphs [0020], [0058], [0061]-[0062], [0065], [0069]-[0070], [0114]-[0115] and [0201]; claim 1; and figures 4-6. | 1-7,20-22 |
| A | | 8-19 |
| Y | KR 10-2017-0030735 A (LG DISPLAY CO., LTD.) 20 March 2017 (2017-03-20)<br>See paragraphs [0080] and [0082]; claim 4; and figure 9. | 1-7,20-22 |
| A | KR 10-2020-0115832 A (SAMSUNG DISPLAY CO., LTD.) 08 October 2020 (2020-10-08)<br>See paragraphs [0036]-[0055]; and figure 1. | 1-22 |
| A | KR 10-2017-0123578 A (CRUCIALTEC CO., LTD.) 08 November 2017 (2017-11-08)<br>See paragraphs [0027]-[0041]; and figures 1a-3. | 1-22 |
| A | US 2019-0018540 A1 (SAMSUNG DISPLAY CO., LTD.) 17 January 2019 (2019-01-17)<br>See paragraphs [0054]-[0072]; and figures 1 and 4. | 1-22 |

☐ Further documents are listed in the continuation of Box C.   ☑ See patent family annex.

| | | |
| --- | --- | --- |
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
| --- | --- |
| **01 November 2022** | **01 November 2022** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

| International application No. |
|---|
| **PCT/KR2022/010673** |

| Patent document cited in search report | | | Publication date (day/month/year) | Patent family member(s) | | | Publication date (day/month/year) |
|---|---|---|---|---|---|---|---|
| KR | 10-2021-0086907 | A | 09 July 2021 | CN | 113130602 | A | 16 July 2021 |
| | | | | US | 2021-0200366 | A1 | 01 July 2021 |
| KR | 10-2017-0030735 | A | 20 March 2017 | | None | | |
| KR | 10-2020-0115832 | A | 08 October 2020 | CN | 111753627 | A | 09 October 2020 |
| | | | | US | 2020-0311373 | A1 | 01 October 2020 |
| KR | 10-2017-0123578 | A | 08 November 2017 | CN | 108604296 | A | 28 September 2018 |
| | | | | KR | 10-1957913 | B1 | 18 March 2019 |
| | | | | WO | 2017-188715 | A2 | 02 November 2017 |
| | | | | WO | 2017-188715 | A3 | 02 August 2018 |
| US | 2019-0018540 | A1 | 17 January 2019 | CN | 109240528 | A | 18 January 2019 |
| | | | | EP | 3428783 | A1 | 16 January 2019 |
| | | | | KR | 10-2019-0007140 | A | 22 January 2019 |
| | | | | KR | 10-2364418 | B1 | 18 February 2022 |
| | | | | US | 10627955 | B2 | 21 April 2020 |

Form PCT/ISA/210 (patent family annex) (July 2022)